(19) Europäisches Patentamt / European Patent Office / Office européen des brevets

(11) **EP 1 805 879 B1**

(12) **EUROPÄISCHE PATENTSCHRIFT**

(45) Veröffentlichungstag und Bekanntmachung des Hinweises auf die Patenterteilung:
**07.05.2008   Patentblatt 2008/19**

(21) Anmeldenummer: **05802968.7**

(22) Anmeldetag: **26.10.2005**

(51) Int Cl.:
**H02M 1/12** *(2006.01)*          **H01F 27/28** *(2006.01)*

(86) Internationale Anmeldenummer:
**PCT/EP2005/011471**

(87) Internationale Veröffentlichungsnummer:
**WO 2006/048161 (11.05.2006 Gazette 2006/19)**

(54) **MEHRPHASEN-NETZFILTER**

MULTI-PHASE NETWORK FILTER

FILTRE RESEAU POLYPHASE

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **29.10.2004   DE 102004052700**

(43) Veröffentlichungstag der Anmeldung:
**11.07.2007   Patentblatt 2007/28**

(73) Patentinhaber: **Brinkmann GmbH & Co. KG 32683 Barntrup (DE)**

(72) Erfinder: **ENGELAGE, Thorsten 32479 Hille (DE)**

(74) Vertreter: **Schoppe, Fritz et al Schoppe, Zimmermann, Stöckeler & Zinkler Patentanwälte Postfach 246 82043 Pullach bei München (DE)**

(56) Entgegenhaltungen:
**EP-A- 1 096 634          WO-A- 90/10339
DE-A1- 3 826 524          DE-A1- 19 829 424
US-A1- 2004 100 347**

- **PATENT ABSTRACTS OF JAPAN Bd. 2000, Nr. 01, 31. Januar 2000 (2000-01-31) -& JP 11 273975 A (MATSUSHITA ELECTRIC IND CO LTD), 8. Oktober 1999 (1999-10-08)**
- **PATENT ABSTRACTS OF JAPAN Bd. 2000, Nr. 21, 3. August 2001 (2001-08-03) & JP 2001 092540 A (TOSHIBA CORP), 6. April 2001 (2001-04-06)**

**Beschreibung**

Die vorliegende Erfindung bezieht sich im Allgemeinen auf ein Mehrphasen-Netzfilter, im Speziellen auf ein passives Oberschwingungsfilter als Front End an nichtlinearen Verbrauchern.

Der stark zunehmende Anteil der Leistungselektronik am Energieversorgungsnetz, speziell im Bereich der Antriebstechnik, bedeutet eine steigende Verzerrung der Versorgungsspannung durch den hohen Oberschwingungsgehalt des Stromes. Zur Vermeidung von Oberschwingungsströmen in den Versorgungsnetzen wurden in den letzten Jahren in Europa Normen erlassen, die bestimmte Richtlinien für Hersteller von elektrischen und elektronischen Geräten vorschreiben.

Zur Einhaltung der erlassenen Normen, Richtlinien und Empfehlungen existieren verschiedene aktive und passive Lösungen von verschiedenen Herstellern weltweit. Je nach Leistung und Anwendung der Geräte oder dem Einsatz der Geräte beim Endkunden können diese Lösungen Vor- bzw. Nachteile haben. Im Wesentlichen sind die derzeit verfügbaren aktiven oder passiven Geräte und Filter zur Reduzierung von Stromoberschwingungen vom Bauvolumen her oder von den Kosten nicht besonders attraktiv und finden daher nur bedingt Einsatz.

Für elektronische Geräte mit interner B2 bzw. B6 Gleichrichterschaltung werden folgende herkömmliche Methoden zur Reduzierung der Stromoberschwingungen verwendet: AC- und DC-Drosseln, höherpulsige Gleichrichterschaltungen über B12, B18 oder B24, Saugkreisanlagen, Tiefpaßfilter für 50 Hz oder 60 Hz, spezielle Oberschwingungsfilter, Einrichtungen zur aktiven sinusförmigen Stromaufnahme (sogenannte Active Front Ends) und aktive Oberschwingungsfilter. Die aktiven Oberschwingungsfilter werden hierbei parallel am Netz betrieben.

Im Folgenden werden spezielle Oberschwingungsfilter näher betrachtet. Die bislang verfügbaren speziellen Oberschwingungsfilter weisen eine Vielzahl von Nachteilen auf, erreichen teilweise sehr große Bauvolumen verglichen zum Verbraucher oder generieren immense Kosten, die oftmals die eigentlichen Gerätekosten des angeschlossenen Verbrauchers übersteigen.

Da die Schaltungsanordnung spezieller Oberschwingungsfilter grundsätzlich aus induktiven und kapazitiven Komponenten besteht, treten beim Betrieb der Filter im Wesentlichen drei Probleme auf. Hohe Induktivitätswerte im Längszweig eines Filters führen zu lastabhängigem Spannungsabfall und können in reduzierter Zwischenkreisspannung (Gleichspannung nach einem Gleichrichter) resultieren. Dieser Effekt wird zwar teilweise durch die Anschaltung von Kapazitäten wieder egalisiert, da Kapazitäten die Spannung wieder anheben, doch eine lastabhängige Spannungsänderung bleibt erhalten.

Außerdem erzeugen in einem Querzweig verschaltete Kondensatoren einen kapazitiven Blindstrom, der bereits im Leerlauf in das Oberschwingungsfilter fließt. Ein Anteil an kapazitivem Blindstrom ist grundsätzlich sehr gering zu halten, da diese sogenannte Überkompensation von den Energieversorgungsunternehmen nicht erwünscht ist. Einige Hersteller spezieller Oberschwingungsfilter bieten daher die Möglichkeit, die Kondensatoren unter Teillastbedingungen teilweise oder ganz mit Hilfe eines Schützes abzuschalten. Das wiederum erhöht die Kosten und Komplexität, da ein solches Schütz für kapazitiven Strom geeignete Kontakte besitzen sollte und da das Filter mit in einem Steuerungsablauf integriert werden muss.

Als weiterer Nachteil von herkömmlichen speziellen Oberschwingungsfiltern ist das Resonanzverhalten von LC-Verschaltungen zu erwähnen. Grundsätzlich haben alle Schaltungen bestehend aus induktiven und kapazitiven Komponenten mindestens eine Resonanzstelle. Bei den Filtern wird zwar darauf geachtet, dass man mit den auftretenden Frequenzen möglichst nicht in den Bereich der Resonanzstellen kommt, doch ist dies bei dynamischen Lastwechseln in Verbindung mit Lastwechseln am Versorgungsnetz bzw. dem Zu- oder Abschalten von an dem Versorgungsnetz installierten Kompensationsanlagen teilweise kaum abschätzbar.

Es zeigt sich also, dass herkömmliche spezielle Oberschwingungsfilter gravierende technische und wirtschaftliche Nachteile besitzen, die den Einsatz erschweren bzw. verteuern.

Die WO 96/01517 zeigt eine Null-Sequenz-Induktivität zur Verwendung in einer HVDC-Übertragung. Dabei ist jede Phasenwicklung in drei in Serie geschaltete Abschnitte aufgeteilt. Jeder dieser Abschnitte ist auf verschiedenen von drei Schenkeln eines Filterkerns angeordnet. Radiale Positionen der Abschnitte sind zwischen den drei Schenkeln permutiert.

Es ist die Aufgabe der vorliegenden Erfindung, ein Mehrphasen-Netzfilter zu schaffen, das als spezielles Oberschwingungsfilter ausgelegt ist und gegenüber herkömmlichen Oberschwingungsfiltern ein geringeres Bauvolumen, eine geringere Verlustleistung und geringere Kosten aufweist.

Diese Aufgabe wird durch ein Mehrphasen-Netzfilter gemäß Anspruch 1 gelöst.

Die vorliegende Erfindung schafft ein Mehrphasen-Netzfilter mit einem ersten Filterzweig zwischen einem ersten Filtereingang und einem ersten Filterausgang, wobei der erste Filterzweig eine erste Serienschaltung von zumindest zwei Induktivitäten aufweist, die auf unterschiedliche Schenkel eines mehrschenkligen Filterkerns gewickelt sind, und einem zweiten Filterzweig zwischen einem zweiten Filtereingang und einem zweiten Filterausgang, wobei der zweite Filterzweig eine zweite Serienschaltung von zumindest zwei Induktivitäten aufweist, die auf die unterschiedlichen Schenkel des mehrschenkligen Filterkerns gewickelt sind.

Es ist der Kerngedanke der vorliegenden Erfindung, dass es vorteilhaft ist, mehrere Induktivitäten, die Teil eines Filterzweigs zwischen einem Filtereingang und einem Filterausgang sind, auf verschiedene Schenkel eines mehrschenkligen Filterkerns zu verteilen. Es wurde erkannt, dass eine solche Aufteilung der Induktivitäten zu einer Reduzierung des effektiven Spannungsabfalls über dem Längszweig eines Filters führt. Es kann nämlich durch die erfindungsgemäße Verteilung der Wicklungen eines Filterzweigs auf mindestens zwei Schenkel eines mehrschenkligen Filterkerns eine Verringerung oder gar eine Auslöschung einzelner Flusskomponenten in dem Filterkern erreicht werden. Dies ermöglicht eine Verringerung des Bauvolumens, da die in dem Filterkern gespeicherte magnetische Feldenergie verkleinert wird.

Eine Verringerung der Feldenergie ist dadurch möglich, dass die Ströme in den einzelnen Filterzweigen des Mehrphasen-Netzfilters gegeneinender eine vorgegebene Phasenbeziehung aufweisen. Somit weisen auch die durch die Ströme hervorgerufenen magnetischen Flüsse, die die einzelnen Induktivitäten durchsetzen, eine vorgegebene Phasenbeziehung auf. Überlagern sich nun die Magnetfelder, die von Strömen in mindestens zwei Filterzweigen erzeugt werden, so kann dies zu einer Reduzierung des gesamten magnetischen Flusses führen. Verringert sich aber der magnetische Fluss durch eine Induktivität, so verringert sich damit auch der Spannungsabfall über der Induktivität. Dies hat insgesamt zur Folge, dass der Spannungsabfall über einem erfindungsgemäßen Mehrphasen-Netzfilter geringer ist als über einem herkömmlichen Netzfilter. Auch die Lastabhängigkeit der Ausgangsspannung an dem Filterausgang bzw. an dem Ausgang eines dem Filter nachgeschalteten Gleichrichters ist verringert. Weiterhin kann die Baugröße des erfindungsgemäßen Mehrphasen-Netzfilters geringer sein als bei herkömmlichen Filteranordnungen. Somit verringern sich schließlich auch die Kosten für ein Filter. Daneben sind auch die Verluste in dem Filter reduziert, da der Spannungsabfall insgesamt kleiner ist.

Querinduktivitäten in dem Mehrphasen-Netzfilter können mit geringeren Drahtstärken ausgeführt werden, da die in dem Filter insgesamt gespeicherte Energie durch die erfindungsgemäße Verteilung der Längswindungen auf mehrere Schenkel des Filterkerns geringer ist. Damit verringert sich auch die in den Querinduktivitäten zu speichernde Energie, und die Drahtstärken können folglich reduziert werden. In ähnlicher Weise können kapazitive Energiespeichereinrichtungen, die ebenfalls Teil eines Mehrphasen-Netzfilters sind, kleiner ausgeführt werden, da auch die von den kapazitiven Energiespeichern zu liefernde Energie geringer ist. Verkleinerte kapazitive Energiespeichereinrichtungen führen aber zu einem verkleinerten kapazitiven Blindstrom im Leerlauf des Mehrphasen-Netzfilters bzw. unter Teillastbedingungen. Somit wird es überflüssig, die kapazitiven Energiespeichereinrichtungen in einem Leerlaufbetrieb oder in einem Teillastbetrieb abzuschalten. Dies führt zu einer erheblichen Vereinfachung der Filter- und Anlagensteuerung, was einen schnelleren kostengünstigeren Aufbau einer Anlage mit einem erfindungsgemäßen Netzfilter ermöglicht.

Bei einem bevorzugten Ausführungsbeispiel ist das Mehrphasen-Netzfilter ausgelegt, um Nutz-Wechselströme mit einer vorgegebenen Frequenz von dem ersten Filtereingang zu dem ersten Filterausgang und von dem zweiten Filtereingang zu dem zweiten Filterausgang weiterzuleiten, und um Störströme mit einer anderen als der vorgegebenen Frequenz, die an dem ersten Filterausgang oder dem zweiten Filterausgang auftreten, an dem ersten Filtereingang oder dem zweiten Filtereingang zu dämpfen. Eine solche Auslegung des Mehrphasen-Netzfilters ist vorteilhaft, da hier davon ausgegangen wird, dass Störströme von einem an dem Filterausgang angeschlossenen Verbraucher erzeugt werden und nicht an das Stromversorgungsnetz, das mit dem Filtereingang gekoppelt ist, weitergegeben werden sollen. Daher ist das Hauptaugenmerk darauf zu richten, dass Störungen, insbesondere Oberschwingungsströme bzw. Netzrückwirkungen, nicht von dem Filterausgang zu dem Filtereingang übertragen werden. Die genannten unerwünschten Effekte werden im Folgenden kurz als Störungen bezeichnet. Hingegen ist ein erfindungsgemäßes Netzfilter ausgelegt, um den Nutzwechselstrom, der typischerweise eine Frequenz von 16 $\frac{2}{3}$ Hz, 50 Hz, 60 Hz oder 400 Hz hat, von dem Filtereingang zu dem Filterausgang weiterzuleiten. Damit ist eine Versorgung des Verbrauchers gewährleistet. Eine entsprechende Filterauslegung ermöglicht es, dass an dem Filterausgang ein beliebig verzerrter Stromverlauf, beispielsweise auch ein näherungsweise blockförmiger Stromverlauf, bereitgestellt werden kann, während die Stromaufnahme an dem Filtereingang im Wesentlichen sinusförmig ist. Die höherfrequenten Stromanteile, die nötig sind, um an dem Filterausgang gegenüber der Sinusform verzerrte Stromverläufe zu erzeugen, werden bei einer geeigneten Filterauslegung durch induktive und auch durch kapazitive Energiespeicherelemente bereitgestellt. Damit können an dem erfindungsgemäßen Filter Verbraucher mit nahezu beliebigem Verlauf des Eingangsstroms betrieben werden, ohne dass in das eingangsseitige Energieversorgungsnetz höherfrequente Störströme, die beispielsweise auf Oberschwingungsströmen oder anderweitigen Netzrückwirkungen eines an ein Filter angeschlossenen Verbrauchers beruhen, eingeprägt werden. Alle derartigen unerwünschten Stromflüsse werden im Folgenden kurz als Störströme bezeichnet.

Bei einem weiteren bevorzugten Ausführungsbeispiel umfasst ein Filterzweig des Mehrphasen-Netzfilters eine erste Induktivität, die zwischen den jeweiligen Filtereingang und einen inneren Knoten des jeweiligen Filterzweigs geschaltet ist, eine zweite Induktivität, die zwischen den inneren Knoten und den jeweiligen Filterausgang geschaltet ist sowie eine dritte Induktivität, die Teil eines Querzweigs ist und mit dem inneren Knoten verschaltet ist. Die beiden Längsinduktivitäten, die zwischen den Filtereingang und den inneren Knoten bzw. zwischen den Filterausgang und den inneren Knoten geschaltet sind, sind bevorzugterweise auf verschiedene Schenkel des mehrschenkligen Filterkerns gewickelt, und zwar so, dass die eingangsseitige Induktivität des zweiten Filterzweigs auf den gleichen Filterschenkel gewickelt ist wie die ausgangsseitige Induktivität des ersten Filterzweigs. Durch diese Anordnung wird eine Verkoppelung der beiden Filterzweige, die zu zwei verschiedenen Phasen der Netzstromversorgung gehören, erreicht. Bei einer vorbeschriebenen Anordnung wird eine vorteilhafte T-Struktur des Filters, die eine gute Dämpfung von ausgangsseitigen Störungen ermöglicht, mit einer Verkoppelung von mindestens zwei Filterzweigen verbunden. Es zeigt sich hierbei insbesondere, dass zur Herstellung der Verkoppelung zwischen mehreren Filterzweigen im Vergleich zu einer herkömmlichen T-Filterstruktur keine zusätzlichen Wicklungen erforderlich sind. Die Induktivität des Querkreises kann weiterhin auf einen geeigneten Filterschenkel gewickelt werden, wobei dies sowohl der Schenkel, auf dem sich die eingangsseitige Wicklung befindet, als auch der Schenkel, auf dem sich die ausgangsseitige Wicklung befindet, sein kann. Durch eine flexible Plazierung der Wicklungen kann das Filter an die jeweiligen Aufgaben und Anforderungen angepaßt werden.

Weiterhin wird es bevorzugt, dass in dem Querzweig eines Filterzweigs eine kapazitive Energiespeichereinrichtung eingeschaltet ist. Diese ist bei einem bevorzugten Ausführungsbeispiel über eine Induktivität mit dem Längszweig gekoppelt. Es wird eine symmetrische Auslegung der verschiedenen Filterzweige bevorzugt, so dass auch ein zweiter und ein eventuell vorhandener dritter Filterzweig mit der kapazitiven Energiespeichereinrichtung gekoppelt sind. Eine kapazitive Energiespeichereinrichtung ermöglicht es, Energie zu den Zeiten bereitzustellen, in denen die Energie in den Induktivitäten minimal ist. Das Mehrphasen-Netzfilter ist durch die Einführung von kapazitiven Energiespeichern in der Lage, zusätzlich zu dem an dem Filtereingang anliegenden Versorgungsstrom eine weitere Stromkomponente abzugeben bzw. aufzunehmen, so dass nicht-sinusförmige Ausgangsstromverläufe erzielbar sind. Die Einschaltung einer kapazitiven Energiespeichereinrichtung in einen Querzweig ist weiterhin auch vorteilhaft, da eine Kapazität in der Lage ist, hochfrequente Stromanteile kurzzuschließen. Somit verringert die Kapazität in dem Querzweig die Übertragung von hochfrequenten Stromanteilen von dem Filterausgang zu dem Filtereingang. Gerade in Verbindung mit einem erfindungsgemäßen Filterkonzept, bei dem Induktivitäten mehrerer Filterzweige durch Anbringung an einen gemeinsamen Schenkel des Filterkerns miteinander verkoppelt sind, ist der Einsatz von kapazitiven Energiespeicherelementen sehr vorteilhaft. Durch die Verkoppelung der Induktivitäten wird die induktiv gespeicherte Energie verringert. Dies hat zur Folge, dass auch die kapazitive Blindenergie in dem Filter verringert werden kann. Somit können die kapazitiven Energiespeichereinrichtungen in Verbindung mit den erfindungsgemäß gekoppelten Induktivitäten gegenüber herkömmlichen Realisierungen wesentlich verkleinert werden. Somit kann durch eine Kombination von Kapazitäten und einem erfindungsgemäßen Filterkonzept der Vorteil erreicht werden, dass die Baugröße der Kapazitäten verringert werden kann. Dies senkt die von den Kapazitäten in einem Leerlaufbetrieb aufgenommene Blindleistung und trägt zu einer Kostenreduzierung bei.

Es ist weiterhin möglich, kapazitive Energiespeicherelemente direkt, d.h. ohne Zwischenschaltung einer Querinduktivität, mit den Knoten zu koppeln, an denen die verschiedenen Längsinduktivitäten gekoppelt sind. Ein solcher Aufbau kann vorteilhaft sein, um eine noch stärkere Bedämpfung von O-berschwingungen hoher Ordnung zu erzielen. Es liegt nämlich hierbei keine Induktivität mehr in Serie zu den Kapazitäten. Die Kapazitäten können somit ihre Energie direkt in den Längszweig einkoppeln. Weiterhin ist der Betrag der Impedanz eines kapazitiven Elements bei hohen Frequenzen sehr niedrig. Somit ist mit einer guten Ableitung von hochfrequenten Strömen, die an dem Ausgang des Filters anliegen, zu rechnen. Auch die Schaltungsstruktur vereinfacht sich, wenn keine Querinduktivitäten, die zwischen den Längszweig und die kapazitiven Energiespeicherelemente geschaltet sind, mehr benötigt werden.

Es wird weiterhin bevorzugt, dass das Mehrphasen-Netzfilter ein Dreiphasen-Netzfilter ist. Hierbei wird bevorzugterweise ein dreiphasiger Filterkern verwendet. Es existieren drei Filterzweige, die zwischen Filtereingang und Filterausgang jeweils eine Serienschaltung von mindestens zwei Induktivitäten aufweisen. Die eingangsseitigen und ausgangsseitigen Induktivitäten in diesem Zweig sind jeweils um unterschiedliche Schenkel des dreiphasigen Filterkerns gewickelt. Eine dreiphasige Auslegung bringt den erheblichen Vorteil, dass das Mehrphasen-Netzfilter somit in Verbindung mit herkömmlichen Drehstromnetzen eingesetzt werden kann. Weiterhin besteht bei einer dreiphasigen Auslegung der Vorteil, dass die durch das Drehstromnetz vorgegebene Phasenbeziehung zwischen den einzelnen Phasen und somit zwischen den Strömen in den einzelnen Filterzweigen in besonders vorteilhafter Weise eine Verkoppelung der Filterzweige und eine Verringerung bzw. Auslöschung von Flusskomponenten in dem dreiphasigen Filterkern ermöglicht. Bei einem dreiphasigen Filter existieren nämlich drei Phasen, die um jeweils 120 Grad gegeneinander in der Phasenlage verschoben sind. Dies gilt sowohl für die Spannungen als auch für die Ströme sowie für die von den Strömen erzeugten Magnetfelder. Eine Überlagerung aller drei Phasen kann hierbei zu einer Reduzierung des Magnetfelds bzw. des magnetischen Flusses führen. Eine dreiphasige Auslegung ist besonders gut geeignet, um den magnetischen Fluss in dem Netzfilter zu verringern, wodurch sich die in dem Filter gespeicherte Energie und die mechanische Baugröße des Filters verringert. Auch die Verlustleistung sinkt bei hinreichend starker Verringerung der magnetischen Flüsse. Eine dreiphasige Auslegung des Filters führt in Verbindung mit einem herkömmlichen Drehstromnetz im Übrigen zu einer gleichmäßigen Netzbelastung, was von den Energieversorgungsunternehmen gewünscht ist. Somit stellt die dreiphasige Auslegung des Netzfilters in der praktischen Anwendung den wichtigsten Einsatzfall dar, und ist mit erheblichen Vorteilen verbunden.

Bei einem dreiphasigen Netzfilter wird es bevorzugt, dass jeder der drei Filterzweige je drei in Serie zwischen den jeweiligen Filtereingang und den jeweiligen Filterausgang geschalteten Induktivitäten umfasst, wobei die Induktivitäten eines jeden Zweigs bevorzugterweise auf alle drei Schenkel eines dreiphasigen Filterkerns aufgeteilt sind. Somit ist jeder Filterzweig mit den beiden anderen Filterzweigen magnetisch verkoppelt. Dies resultiert in einer maximalen Symmetrie der Anordnung. Die Verkoppelung eines jeden Zweiges mit den beiden anderen Zweigen ist bei einer dreiphasigen Auslegung besonders vorteilhaft. Grund dafür ist die Phasenverschiebung von 120 Grad zwischen den einzelnen Zweigen. Eine Koppelung eines Zweiges mit nur einem anderen Zweig würde aufgrund der Phasenbeziehung zwischen den beiden Zweigen (Phasenunterschied 120 Grad) nur zu einer geringen Verringerung des magnetischen Flusses sowie zu einer Veränderung der Phasenlage führen. Wird hingegen ein Zweig mit beiden anderen Zweigen verkoppelt, so führt dies zu einer deutlicheren Verringerung des magnetischen Flusses, wobei die ursprüngliche Phasenlage beibehalten wird. Die Verringerung des magnetischen Flusses ist hierbei von der Stärke der Kopplung mit den beiden anderen Zweigen abhängig. Es wird als vorteilhaft erachtet, die Koppelstärke mit den beiden andren Zweigen jeweils gleich auszulegen. In diesem Fall ist eine maximale Symmetrie gewährleistet, und Phasenabweichungen werden vermieden.

Bevorzugterweise weisen die Induktivitäten des ersten, zweiten und dritten Filterzweigs innerhalb eines Zweiges und auch zwischen den Zweigen den gleichen Wickelsinn auf. Eine solche Auslegung ermöglicht es, dass ein Strom von dem Filtereingang zu dem Filterausgang bei geringst möglichem Spannungsabfall und geringst möglichen Verlusten übertragen werden kann. Ein Störstrom hingegen, der beispielsweise eine Stromoberschwingung oder eine Netzrückwirkung darstellt, und der an dem Filterausgang eingekoppelt wird, ist über den Querzweig des Filters abzuführen. Dies wird durch den Wickelsinn insofern erleichtert, als ein von dem Ausgang aus eingekoppelter Strom erst die ausgangsseitigen Induktivitäten und dann die Querinduktivitäten in entgegengesetztem Umlaufsinn durchläuft. Somit wird die für einen von dem Ausgang des Filters eingekoppelten Strom sichtbare effektive Induktivität bei geeigneter Auslegung der Wicklungsrichtung minimal. Ein Nutzstrom, der an dem Filtereingang eingekoppelt wird, durchläuft hingegen die eingangsseitige Induktivität und die Induktivität des Querzweigs in einer gleichen Richtung. Die wirksame Induktivität wird hierdurch maximiert, und der Nutzstrom wird durch den Querzweig nicht kurzgeschlossen, sondern an den Ausgang weitergeleitet. Insofern ist die Festlegung des Wickelsinns ein wesentlicher Freiheitsgrad bei dem Entwurf eines Netzfilters. Es wurde hier erkannt, dass die Verwendung eines gleichen Wickelsinns bei allen Induktivitäten vorteilhaft ist.

Weiterhin wird es auch bei einer dreiphasigen Auslegung des Netzfilters bevorzugt, dass die Induktivitäten in den einzelnen Filterzweigen hinsichtlich der Windungszahlen und der Verteilung auf die Schenkel des Dreiphasenkerns so ausgelegt werden, dass der magnetische Fluss in einem Schenkel, bezogen auf eine Filteranordnung, bei der die Induktivitäten eines Filterzweigs auf nur einen Schenkel des dreiphasigen Filterkerns gewickelt sind, reduziert ist. Wie schon vorstehend erläutert, ist es vorteilhaft, das Filter so auszulegen, dass der magnetische Fluss in den Schenkeln des Dreiphasenkerns so klein als möglich ist. Damit kann die mechanische Bauform des Filters verringert werden. Gleichzeitig werden Verluste verringert. Außerdem können die kapazitiven Energiespeicherelemente dann kleiner ausgelegt werden.

Auch bei einem dreiphasigen Netzfilter ist es sinnvoll, eine kapazitive Energiespeichereinrichtung an Knoten zwischen den Längsinduktivitäten eines jeden Filterzweigs, die zwischen Filtereingang und Filterausgang in Serie geschaltet sind, anzukoppeln. Die Ankoppelung kann entweder direkt oder über eine weitere Induktivität erfolgen. Vorteile einer solchen Verschaltung wurden bereits erörtert und werden hier nicht mehr wiederholt.

Als Energiespeichereinrichtung kann bevorzugterweise eine Sternschaltung von Kondensatoren oder eine Dreiecksschaltung von Kondensatoren verwendet werden. Beide Schaltungsformen sind im Bereich der Energietechnik üblich und können mit vertretbarem Aufwand realisiert werden.

Es wird weiterhin bevorzugt, dass das Netzfilter so ausgelegt ist, dass ein Strom, der bei einer vorgegebenen Nutzfrequenz durch den ersten, zweiten oder dritten Anschluss der kapazitiven Energiespeichereinrichtung fließt, vom Betrag her kleiner ist als ein Viertel des Nennstroms bzw. Bemessungsstroms, der bei einer Nennbelastung des Filters durch den ersten, zweiten oder dritten Filtereingang fließt. Eine solche Auslegung wird durch die erfindungsgemäße Aufteilung der Längsinduktivitäten eines Filterzweigs auf mehrere Schenkel des mehrschenkligen Filterkerns erst ermöglicht. Wird die Mitkopplung der einzelnen Wicklungen ausgenutzt, so muss der in dem Querzweig bei der Frequenz des Nutzstroms fließende Strom im Vergleich zu herkömmlichen Anordnungen nur vergleichsweise gering sein. Die Verwendung eines kleineren Stroms durch die Querinduktivität ermöglicht es nun, einen dünneren Draht zu verwenden als dies herkömmlicherweise der Fall ist. Somit können bei gleicher Baugröße wesentlich mehr Windungen für die Querinduktivität verwendet werden. Da die Induktivität bei vorgegebenem Kern proportional zu dem Quadrat der Windungszahl ist, lässt sich so eine wesentlich erhöhte Induktivität der Querinduktivität erzielen. Gemäß dem vorliegendem Schaltungskonzept resultiert dies darin, dass die Längsinduktivitäten, die zwischen dem Filtereingang und dem Filterausgang liegen, verkleinert werden können. Dies spart sowohl Bauvolumen als auch Kosten. Weiterhin verringert sich durch die erfindungsgemäße Auslegung des Stroms, der in die Energiespeichereinrichtung fließt, der Blindstrom im Leerlauf. Es ist somit keine Abschaltung der Kondensatoren in einem Leerlaufbetrieb oder einem Teillastbetrieb mehr nötig, wie dies bei herkömmlichen Filteranordnungen üblich ist. Somit ist ein Schaltschütz nicht mehr nötig. Dies führt freilich zu einer Kostensenkung. Weiterhin ist eine Ansteuerung der Schalteinrichtung ebenso überflüssig, wodurch sich wiederum der Aufwand zum Aufbau eines Netzfilters verringert und wodurch das Filter problemlos in Verbindung mit jedem beliebigen Verbraucher betrieben werden kann, ohne dass eine Anpassung nötig ist. Durch den gegenüber herkömmlichen Anordnungen verringerten Strom durch die induktiven Energiespeicherelemente der Querzweige wird eine Überkompensation auch im Leerlauf reduziert. Somit können die Vorgaben der Energieversorgungsunternehmen im Bezug auf die Netzbelastung eingehalten werden. Schließlich erfordert ein verringerter Stromfluss in die kapazitiven Energiespeicherelemente auch kleinere Kapazitäten, was wiederum zu einer Reduzierung von Bauvolumen und Kosten führt.

Bevorzugte Ausführungsbeispiele der vorliegenden Erfindung werden nachfolgend Bezug nehmend auf die beiliegenden Zeichnungen näher erläutert. Es zeigen:

Fig. 1    eine schematische Darstellung eines erfindungsgemäßen mehrphasigen Netzfilters gemäß einem ersten Ausführungsbeispiel der vorliegenden Erfindung;

Fig. 2    ein Schaltbild eines erfindungsgemäßen breitbandigen Netzfilters gemäß einem zweiten Ausführungsbeispiel der vorliegenden Erfindung;

Fig. 3    ein Schaltbild eines erfindungsgemäßen dreiphasigen Netzfilters gemäß einem dritten Ausführungsbeispiel der vorliegenden Erfindung;

Fig. 4    ein Schaltbild eines erfindungsgemäßen dreiphasigen Netzfilters gemäß einem vierten Ausführungsbeispiel der vorliegenden Erfindung;

Fig. 5    ein Schaltbild eines erfindungsgemäßen dreiphasigen Netzfilters gemäß einem fünften Ausführungsbeispiel der vorliegenden Erfindung;

Fig. 6    ein Schaltbild eines erfindungsgemäßen dreiphasigen Netzfilters gemäß einem sechsten Ausführungsbeispiel der vorliegenden Erfindung;

Fig. 7    ein Schaltbild eines erfindungsgemäßen dreiphasigen Netzfilters gemäß einem siebten Ausführungsbeispiel der vorliegenden Erfindung;

Fig. 8    ein Schaltbild eines erfindungsgemäßen dreiphasigen Netzfilters gemäß einem achten Ausführungsbeispiel der vorliegenden Erfindung;

Fig. 9    ein Schaltbild eines erfindungsgemäßen dreiphasigen Netzfilters gemäß einem neunten Ausführungsbeispiel der vorliegenden Erfindung; und

Fig. 10    ein Oszillogramm der Stromverläufe an dem Eingang und dem Ausgang des erfindungsgemäßen Netzfilters gemäß dem zweiten Ausführungsbeispiel der vorliegenden Erfindung.

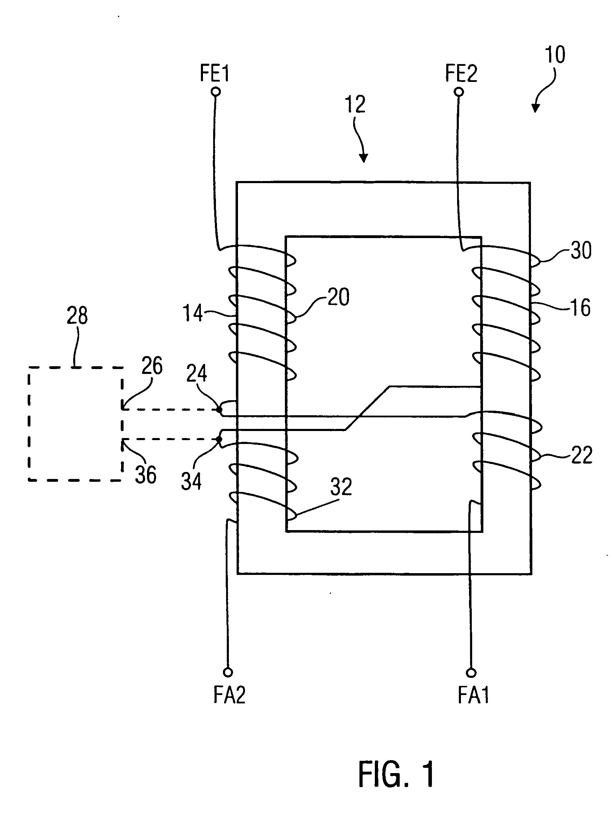

Fig. 1 zeigt eine schematische Darstellung eines erfindungsgemäßen mehrphasigen Netzfilters gemäß einem ersten Ausführungsbeispiel der vorliegenden Erfindung. Das mehrphasige Netzfilter ist in seiner Gesamtheit mit 10 bezeichnet. Das Filter weist einen ersten Filtereingang FE1 sowie einen zweiten Filtereingang FE2 auf, ferner einen ersten Filterausgang FA1 sowie einen zweiten Filterausgang FA2. Des weiteren weist das Filter einen mehrphasigen Filterkern 12 auf, der einen ersten Filterschenkel 14 sowie einen zweiten Filterschenkel 16 umfasst. Eine erste Induktivität 20 ist um den ersten Filterschenkel 14 gewickelt und an dem ersten Ende mit dem ersten Filtereingang FE1 verbunden. Das zweite Ende der ersten Induktivität 20 ist über eine zweite Induktivität 22, die um den zweiten Filterschenkel 16 des mehrphasigen Filterkerns 12 gewickelt ist, mit dem ersten Filterausgang FA1 verbunden. Der Verbindungspunkt 24 der ersten Induktivität 20 und der zweiten Induktivität 22 ist mit einem ersten Eingang 26 einer Querzweigschaltung 28 verbunden. Der zweite Filtereingang FE2 ist über eine dritte Induktivität 30, die um den zweiten Schenkel 16 des mehrphasigen Filterkerns 12' gewickelt ist, und eine vierte Induktivität 32, die um den ersten Schenkel 14 des mehrphasigen Filterkerns 12 gewickelt ist, und die der dritten Induktivität 30 in Serie geschaltet ist, mit dem zweiten Filterausgang FA2 verbunden. Der Verbindungsknoten 34 der dritten Induktivität 30 und der vierten Induktivität 32 ist mit einem zweiten Eingang 36 der Querzweigschaltung 28 verbunden. Zu beachten ist weiterhin, dass alle vier Induktivitäten 20, 22, 30, 32 den gleichen Wicklungssinn aufweisen.

Aufbauend auf der strukturellen Beschreibung wird im Folgenden die Funktionsweise der vorliegenden Schaltung beschrieben. Aufgabe der vorliegenden Schaltungsanordnung ist es, Ströme mit einer vorgegebenen Frequenz von dem ersten Filtereingang FE1 zu dem ersten Filterausgang FA1 sowie von dem zweiten Filtereingang FE2 zu dem zweiten Filterausgang FA2 weiterzuleiten. Störströme mit anderen, insbesondere höheren Frequenzen, die an dem ersten und zweiten Filterausgang FA1, FA2 durch eine hier nicht gezeigte Last eingeprägt sein können, sollen soweit wie möglich gedämpft werden, so dass sie an den Filtereingängen FE1, FE2 nur geringe Störungen (Störströme) verursachen. Dabei soll weiterhin der Spannungsabfall über dem Netzfilter so gering wie möglich sein. Im Übrigen ist festzuhalten, dass zwischen den Strömen in dem ersten Filterzweig (zwischen dem ersten Filtereingang FE1 und dem ersten Filterausgang FA1) und dem zweiten Filterzweig (zwischen dem zweiten Filtereingang FE2 und dem zweiten Filterausgang FA2) eine Phasenverschiebung besteht. Diese ist durch die Eigenschaften eines Versorgungsnetzes, das mit den Filtereingängen FE1, FE2 gekoppelt ist, sowie durch die an den Filterausgängen FA1, FA2 angeschlossene Last festgelegt.

Fließt ein Strom durch den ersten Filterzweig, so prägt dieser durch die erste Induktivität 20 einen magnetischen Fluss in dem ersten Schenkel 14 des mehrphasigen Filterkerns 12 ein. Durch die induktive Wirkung der ersten Induktivität 20 entsteht weiterhin ein Spannungsabfall über der Induktivität 20. Weiterhin durchfließt der Strom die zweite Induktivität 22 und erzeugt so auch in dem zweiten Schenkel 16 des mehrphasigen Filterkerns 12 ein magnetisches Feld. Ebenso entsteht ein Spannungsabfall über der zweiten Induktivität 22. Die Querzweigschaltung 28 ist so ausgelegt, dass der hineinfließende Strom bei der Nutzfrequenz, die gleich der Nennfrequenz des Versorgungsnetzes ist, eine festgelegte Größe nicht überschreitet. Dies wird durch die innere Verschaltung der Querzweigschaltung 28 sichergestellt, auf die hier nicht näher eingegangen wird. Die Schaltung der Querzweigschaltung 28 kann im Wesentlichen aus Induktivitäten und Kapazitäten bestehen, die ausgelegt sind, um bei der Nennfrequenz eine hinreichend große Impedanz darzustellen.

Fließt weiterhin auch durch den zweiten Filterzweig ein Strom, so erzeugt die dritte Induktivität 30 einen magnetischen Fluss in dem zweiten Schenkel 16 des mehrphasigen Filterkerns 12. Wiederum entsteht ein Spannungsabfall über der dritten Induktivität 30. Weiterhin fließt ein Strom durch die vierte Induktivität 32 und trägt zu dem magnetischen Fluß durch den ersten Filterschenkel 14 bei.

Besteht nun zwischen den Strömen in dem ersten und dem zweiten Filterzweig eine Phasenverschiebung, so besteht eine starke Verkoppelung zwischen den Induktivitäten des ersten und des zweiten Filterzweigs. Beispielsweise erzeugt die erste Induktivität 20 einen magnetischen Fluss in dem ersten Filterschenkel 14, der in der vierten Induktivität 32 des zweiten Filterzweigs wiederum eine Spannung induziert. Ist die Phasendifferenz zwischen den Strömen in dem ersten und dem zweiten Filterzweig hinreichend groß, so wirkt diese induzierte Spannung der in der vierten Induktivität 32 durch den Strom in dem zweiten Filterzweig erzeugten Spannung gerade entgegen. Somit verringert sich der Spannungsabfall über dem zweiten Filterzweig. In ähnlicher Weise verringert sich der Spannungsabfall über dem ersten Filterzweig, da beispielsweise in der zweiten Induktivität 22 eine Spannung aufgrund des magnetischen Flusses durch den zweiten Filterschenkel 16, der durch den Stromfluss in dem zweiten Filterzweig über die dritte Induktivität 30 hervorgerufen wird, induziert wird. Eine Betrachtung der magnetischen Koppelung der vier Induktivitäten 20,22,30,32 in den gezeigten Filterzweigen unter Berücksichtigung der Phasenverschiebung zwischen dem ersten Filterzweig und dem zweiten Filterzweig zeigt, dass der Spannungsabfall über dem ersten Filterzweig und dem zweiten Filterzweig durch die Verkoppelung verringert wird.

In ähnlicher Weise lässt sich zeigen, dass bei vorliegender Phasenverschiebung zwischen den Strömen in dem ersten und dem zweiten Filterzweig der gesamte magnetische Fluss in dem ersten Filterschenkel 14 und in dem zweiten Filterschenkel 16 verringert wird. Dies lässt sich beispielsweise erkennen, wenn angenommen wird, dass der Strom in dem ersten Filterzweig gerade dem Strom in dem zweiten Filterzweig entgegengesetzt ist. Dann erzeugt beispielsweise die erste Induktivität 20 einen magnetischen Fluss, der in eine Richtung gerichtet ist, und die vierte Induktivität 32 einen magnetischen Fluss, der in die entgegengesetzte Richtung gerichtet ist. Der gesamte magnetische Fluss in einem Filterschenkel 14,16 ist somit geringer als bei einer Anordnung, bei der keine direkte magnetische Verkoppelung zwischen dem ersten Filterzweig und dem zweiten Filterzweig besteht.

Da die gesamte magnetische Energie in dem Filterkern bei einer erfindungsgemäßen Anordnung geringer ist als bei einer Anordnung, bei der keine direkte magnetische Verkoppelung zwischen den Filterzweigen besteht, kann der Filterkern 12 entsprechend kleiner ausgelegt werden. Da die in der ersten, zweiten, dritten und vierten Induktivität 20, 22, 30, 32 gespeicherte Energie kleiner als bei herkömmlichen Anordnungen ist, muss auch die Querzweigschaltung 28 nur eine geringere Energie speichern. Daher können die Bauelemente der Querzweigschaltung 28, die im Wesentlichen Induktivitäten und Kapazitäten umfasst, kleiner ausgelegt werden. Dies spart Kosten und Bauraum.

Somit bringt ein erfindungsgemäßes mehrphasiges Netzfilter 10 gemäß dem ersten Ausführungsbeispiel der vorliegenden Erfindung den Vorteil, dass der Spannungsabfall über dem Filter sowie die in dem Filterkern 12 gespeicherte Energie geringer sind als bei vergleichbaren herkömmlichen Filteranordnungen. Auch die Querzweigschaltung 28 des Netzfilters kann kleiner ausgelegt werden, was weitere Vorteile mit sich bringt.

Es ist schließlich festzuhalten, dass das gezeigte Filter auch ein Teil einer größeren Filteranordnung sein kann, die mehr als zwei Ein- und Ausgänge umfasst und bei der der Kern mehr als zwei Schenkel aufweist.

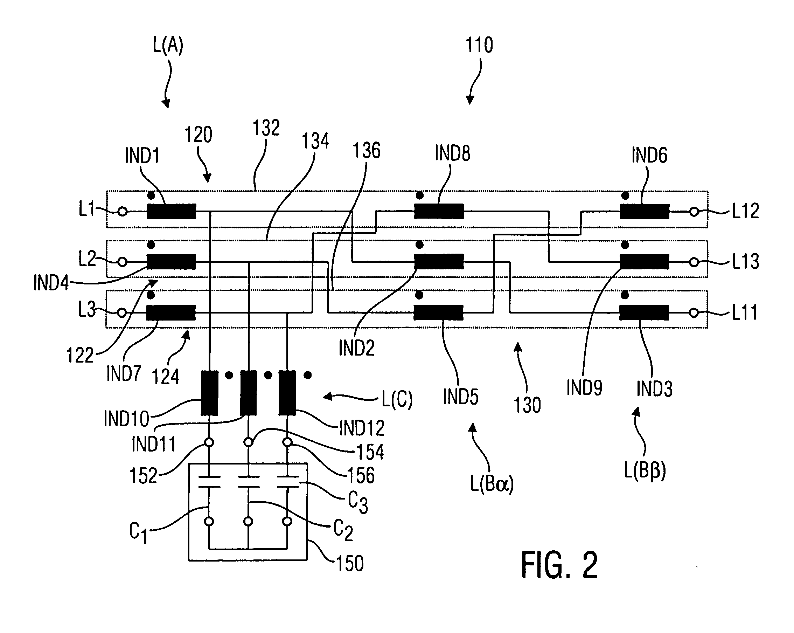

Fig. 2 zeigt ein Schaltbild eines erfindungsgemäßen dreiphasigen Netzfilters gemäß einem zweiten Ausführungsbeispiel der vorliegenden Erfindung. Das Netzfilter ist in seiner Gesamtheit mit 110 bezeichnet. Das Filter umfasst einen ersten Filterzweig 120, der zwischen den ersten Filtereingang L1 sowie einen ersten Filterausgang L11 geschaltet ist, einen zweiten Filterzweig 122, der zwischen den zweiten Filtereingang L2 und den zweiten Filterausgang L12 geschaltet ist sowie einen dritten Filterzweig 124, der zwischen den dritten Filtereingang L3 und den dritten Filterausgang L13 geschaltet ist. Ferner umfasst das Netzfilter 110 einen dreischenkligen Filterkern 130, der einen ersten Schenkel 132, einen zweiten Schenkel 134 sowie einen dritten Schenkel 136 aufweist. Der dreischenklige Filterkern kann bevorzugter Weise ein dreiphasiger Filterkern sei. Der erste Filterzweig umfasst eine erste Induktivität IND1, eine zweite Induktivität IND2 sowie eine dritte Induktivität IND3, die in Serie zwischen den ersten Filtereingang L1 und den ersten Filterausgang L11 geschaltet sind. Die erste Induktivität IND1 ist um den ersten Schenkel 132 gewickelt, die zweite Induktivität IND2 ist um den zweiten Filterschenkel 134 gewickelt und die dritte Induktivität IND3 ist um den dritten Filterschenkel 136 gewickelt. Der zweite Filterzweig 122 ist analog dem ersten Filterzweig ausgeführt, wobei eine vierte Induktivität IND4, eine fünfte Induktivität IND5 sowie eine sechste Induktivität IND6 zwischen den zweiten Filtereingang L2 und dem zweiten Filterausgang L12 geschaltet sind. Die vierte Induktivität IND4 ist auf den zweiten Schenkel 134 gewickelt, die fünfte Induktivität L5 ist auf den dritten Schenkel 136 gewickelt und die sechste Induktivität IND6 ist auf den ersten Schenkel 132 gewickelt. Schließlich umfasst der dritte Filterzweig eine siebte Induktivität IND7, eine achte Induktivität IND8 sowie eine neunte Induktivität IND9, die in Serie zwischen den dritten Filtereingang IND3 und den dritten Filterausgang L13 geschaltet sind. Die siebte Induktivität IND7 ist auf den dritten Schenkel 136 gewickelt, die achte Induktivität IND8 auf den ersten Schenkel 132 und die neunte Induktivität IND9 auf den zweiten Schenkel 134.

Ferner umfasst das dreiphasige Netzfilter 110 Querinduktivitäten IND10, IND11, IND12 sowie eine kapazitive Energiespeichereinrichtung 150 mit einem ersten Anschluss 152, einem zweiten Anschluss 154 und einem dritten Anschluss 156. Dem ersten Filterzweig 120 ist die zehnte Induktivität IND10 zugeordnet. Diese ist mit einem Knoten verbunden, an dem die erste Induktivität IND1 sowie die zweite Induktivität IND2 miteinander gekoppelt sind. Ferner ist die zehnte Induktivität IND10 mit dem ersten Anschluss 152 der kapazitiven Energiespeichereinrichtung 150 verschaltet. In ähnlicher Weise umfasst der zweite Filterzweig 122 eine elfte Induktivität IND11, die zwischen den Knoten, an denen die vierte Induktivität IND4 und die fünfte Induktivität IND5 miteinander verbunden sind, und den zweiten Anschluß 154 der kapazitiven Energiespeichereinrichtung 150 geschaltet ist. Schließlich umfasst der dritte Filterzweig 124 eine zwölfte Induktivität IND12, die zwischen den gemeinsamen Knoten der siebten Induktivität IND7 und der achten Induktivität IND8 und den dritten Anschluß 156 der kapazitiven Energiespeichereinrichtung 150 geschaltet ist. Die kapazitive Energiespeichereinrichtung 150 umfasst drei Kondensatoren C1, C2, C3, die in einer Sternschaltung verschaltet sind.

Weiterhin ist festzuhalten, dass die mechanische Anordnung der einzelnen Induktivitäten sowie der Wicklungssinn festgelegt sind. Auf dem ersten Schenkel 132 sind in dieser Reihenfolge die erste Induktivität IND1, die achte Induktivität IND8 sowie die sechste Induktivität IND6 angebracht. Der zweite Schenkel 134 trägt die vierte Induktivität IND4, die zweite Induktivität IND2 sowie die neunte Induktivität IND9. Der dritte Schenkel schließlich trägt die siebte Induktivität IND7, dann die fünfte Induktivität IND5 und schließlich die dritte Induktivität IND3. Der Wickelsinn aller Induktivitäten ist gleich gewählt. Die genaue Verschaltung der Induktivitäten einschließlich des Wickelsinns ist aus der Fig. 2 zu entnehmen.

Es ist weiterhin festzuhalten, dass der erste, zweite und dritte Eingang L1, L2 und L3 als Netzanschluss dienen. Der erste, zweite und dritte Filterausgang L11, L12, L13 dienen als Geräteanschlusspunkt. Für die weiteren Ausführungen wird ferner angenommen, dass das Netzfilter 110 für alle Phasen symmetrisch ausgelegt ist. Somit werden die eingangsseitigen Induktivitäten IND1, IND4, IND7 bei den folgenden Ausführungen einheitlich als Induktivität $L(A)$ bezeichnet. Die den Eingangsinduktivitäten IND1, IND4, IND7 folgenden Induktivitäten IND2, IND5, IND8 sind ebenfalls gleich ausgeführt und werden im Folgenden als Induktivität $L(B_\alpha)$ referenziert. Die ausgangsseitigen Induktivitäten IND3, IND6, IND9 werden als Induktivität $L(B_\beta)$ bezeichnet. Die Querinduktivitäten IND10, IND11, IND12 schließlich werden gemeinsam als Induktivität $L(C)$ bezeichnet.

Im Folgenden wird die prinzipielle Funktionsweise sowie die Berechnung eines Oberschwingungsfilters beschrieben. Dies wird anhand des dreiphasigen Netzfilters 110 gemäß der Fig. 2 gezeigt. Selbstverständlich ist es möglich, verschiedene Varianten der Schaltungsanordnung in Analogie der hier beschriebenen Schaltung nachzuvollziehen bzw. nachzurechnen.

Im Folgenden wird erst auf die Berechnung des Filters eingegangen. Als Ausgangsbasis für die Berechnung ist der Spannungsabfall über der Längsinduktivität $L_A$ als relative Kurzschlussspannung $u_K$ festzulegen. Der $u_K$-Wert von $L_A$ kann in einem weiteren Bereich gewählt werden. Typischerweise sollten die Werte zwischen 10% und 30% liegen. Grundsätzlich gilt, dass die Erhöhung der Längsinduktivität $L_A$ zu einer Verbesserung des gesamten THDI-Wertes (Gesamte Harmonische Verzerrung am Eingang) führen kann. Mit einer Erhöhung der Längsinduktivität $L_a$ ist aber auch ein höherer Spannungsabfall über das gesamten Filter sowie eine Änderung der Kapazitätswerte verbunden.

Aus dem vorgegebenen Bemessungsstrom des Oberschwingungsfilters 110 errechnet sich dann die eingangsseitige Induktivität $L_A$, die auch mit $L(A)$ bezeichnet ist. Bei Vorgabe von Verhältnissen $L_A/L_B > 1$ und $L_A/L_C > 1$ kann man daraus die restlichen Induktivitätswerte der Induktivitäten $L_B$ und $L_C$ ermitteln. $L_B$ ist hierbei die ausgangsseitige Längsinduktivität des Filters und $L_C$ ist die Querinduktivität des Filters 110. Die ausgangsseitige Längsinduktivität teilt sich hierbei in zwei Induktivitäten $L_{B\alpha}$ und $L_{B\beta}$ auf. Hierbei ist anzumerken, dass $L_{B\alpha}$ auch als $L(B\alpha)$, $L_{B\beta}$ auch als $L(B\beta)$ bezeichnet sind. Die Induktivität $L_A$ sowie die Verhältnisse $L_A/L_B$ und $L_A/L_C$ können beispielsweise anhand von empirischen Erkenntnissen festgelegt werden. Die ermittelten Größen sind somit zuerst Richtgrößen, um auf einen geeigneten dreiphasigen Eisenkern zu schließen. Die Vorgabe der Verhältnisse $L_A/L_B$ bzw. $L_A/L_C$ kann mittels Computersimulation optimiert werden. Je nach Applikation sind andere Verhältnisse zu wählen.

Aus den drei Induktivitätswerten $L_A$, $L_B$ und $L_C$, wobei sich $L_B$ aus $L_{B\alpha}$ und $L_{B\beta}$ zusammensetzt, kann der benötigte Energieinhalt einer dreiphasigen Eisenkerndrossel ermittelt werden. Hierbei wird einer der ganz wesentlichen Vorteile der Erfindung deutlich. Der gesamt benötigte Energieinhalt ist gleich der Differenz aus dem Quadrat des Bemessungsstroms $I_r$ multipliziert mit der eingangsseitigen Induktivität $L_A$ und dem Quadrat des Bemessungsstroms $I_r$ multipliziert mit der ausgangsseitigen Induktivität $L_B$, plus dem Quadrat von 0,25 x $I_r$ multipliziert mit $L_C$. Dies gilt, obwohl der Strom, der durch die beiden ausgangsseitigen Induktivitäten $L_{B\alpha}$ und $L_{B\beta}$ fließt, real etwas geringer ist als der Bemessungsstrom $I_r$ (Eingangsstrom) des Oberschwingungsfilters. Aus dieser Berechnung lässt sich die Reduktion des effektiven Energieinhalts einer Drossel, bei der die eingangsseitige Induktivität $L_A$ eines Filterzweigs auf einen Schenkel eines dreiphasigen Eisenkerns gewickelt ist, und bei der die Wicklungen der ausgangsseitigen Induktivitäten $L_{B\alpha}$, $L_{B\beta}$ auf die anderen Schenkel des dreiphasigen Eisenkerns aufgebracht sind, erkennen. Die teilweise Aufhebung von Flusskomponenten führt zu einem insgesamt benötigten Energieinhalt, der kleiner ist als bei einer Ausführungsform, bei der die eingangsseitige Induktivität $L_A$ und die ausgangsseitige Induktivität $L_B$ eines Filterzweigs auf den gleichen Schenkel eines dreiphasigen Eisenkerns aufgewickelt sind. Es kommt nämlich bei einer erfindungsgemäßen Verteilung der Wicklungen zu einer Differenzbildung von $I_r{}^2 * L_A$ und $I_r{}^2 * L_B$.

Mit den so gewonnenen Daten kann eine korrekte Kerngröße für den dreiphasigen Eisenkern ausgewählt werden. Die Berechnung des $A_L$-Werts ist aus der Literatur bekannt und wird hier nicht weiter ausgeführt. Ist der $A_L$-Wert des Eisenkerns bekannt, so kann die eigentliche Berechnung des Netzfilters 110 durchgeführt werden.

Für die Berechnung wird die Filteranordnung sowohl in einem $\pi$-Ersatzschaltbild als auch in einem T-Ersatzschaltbild beschrieben. Die Induktivitäten $L_A$, $L_{B\alpha}$, $L_{B\beta}$ und $L_C$ sind in T-Schaltungen angeordnet. Sie können die Induktivitäten in $\pi$-Schaltung umgerechnet werden, wobei die Induktivitäten der $\pi$-Schaltung mit $L_X$ (Längsinduktivität), $L_Y$ (erste Querinduktivität) und $L_Z$ (zweite Querinduktivität) bezeichnet werden. Es gilt:

$$L_X = (N_X)^2 * A_L$$
$$L_Y = (N_Y)^2 * A_L \qquad\qquad (1)$$
$$L_Z = (N_Z)^2 * A_L$$

$N_X$, $N_Y$, $N_Z$ sind die Windungszahlen der in $\pi$-Schaltung umgerechneten Induktivitäten $L_x$, $L_y$, $L_z$.

Weiterhin ist es möglich, die Windungszahlen $N_x$, $N_y$, $N_Z$ der Induktivitäten in $\pi$-Schaltung in Windungszahlen $N_A$, $N_{B\alpha}$, $N_{B\beta}$ und $N_C$ der Induktivitäten in T-Schaltung umzurechnen:

$$N_X = N_A - \sqrt{0{,}5}\,{}^*N_{B\alpha} - \sqrt{0{,}5}\,{}^*N_{B\beta}$$
$$N_y = N_A + N_C \qquad\qquad (2)$$
$$N_z = \sqrt{0{,}5}\,{}^*N_{B\alpha} + \sqrt{0{,}5}\,{}^*N_{B\beta} + N_C$$

$N_A$, $N_{B\alpha}$, $N_{B\beta}$ und $N_C$ sind die Windungszahlen der in T-Schaltung angeordneten Induktivitäten $L_A$, $L_{B\alpha}$, $L_{B\beta}$ und $L_C$.

Mit Hilfe der nachstehenden Gleichung können die Induktivitäten $L_A$, $L_{B\alpha}$, $L_{B\beta}$ und $L_C$ der T-Schaltung aus den Induktivitäten $L_x$, $L_y$ und $L_z$ der $\pi$-Schaltung berechnet werden:

$$L_A = 0{,}5*(L_X + L_Y - L_Z)$$
$$L_{B\alpha} = (L_Z - L_Y + (0{,}5*(L_x + L_y - L_z)))/2$$
$$L_{B\beta} = (L_Z - L_Y + (0{,}5*(L_x + L_y - L_z)))/2 \qquad\qquad (3)$$
$$L_C = L_Y - (0{,}5*(L_X + L_Y - L_Z))$$

Ausgehend davon, dass die Induktivitäten der T-Schaltung $L_A$, $L_{B\alpha}$, $L_{B\beta}$ und $L_C$ bekannt sind, können durch Inversion der Formel (3) die Induktivitätswerte einer $\pi$-Schaltung bestimmt werden. Unter Verwendung der Formel (1) können nunmehr die Windungszahlen $N_X$, $N_Y$, $N_Z$ der Induktivitäten in π-Schaltungen bestimmt werden. Schließlich kann das Gleichungssystem (2) invertiert werden, um die Windungszahlen $N_A$, $N_B$, $N_C$ der Induktivitäten in T-Schaltungen zu berechnen. Damit sind alle Induktivitäten der Mehrfachwicklungsdrossel eindeutig bestimmt.

Nach der gezeigten Berechnung bzw. aus diesem Berechnungsbeispiel kann man mühelos den Vorteil der Erfindung erkennen. Nicht nur der bereits beschriebene kleinere benötigte Energieinhalt führt zu einer wesentlichen Reduktion der Baugröße, sondern auch die Ausnutzung der Mitkopplung der einzelnen Windungen. Dadurch kann die Windungszahl $N_C$ der Querinduktivität $L_C$ relativ hoch angesetzt werden. Dies führt bei einem erfindungsgemäßen Netzfilter allerdings nicht, wie bei herkömmlichen Anordnungen üblich, in gleichem Maße zu einer vom Bauvolumen größeren Drossel, da für die Querinduktivität $L_C$ ein geringerer Drahtquerschnitt verwendet werden kann als für die übrigen eingangsseitigen und ausgangsseitigen Induktivitäten. Die Verwendung eines anderen Drahtquerschnitts bzw. das verringerte Bauvolumen der Querinduktivität resultiert aus dem wesentlich kleineren Strom, der in den Querzweig des Oberschwingungsfilters hineinfließt. Da in dem Querzweig des Oberschwingungsfilters und damit durch die Wicklung der Induktivität $L_C$ nur die Oberschwingungsströme und der kapazitive Blindstrom des Kondensators bei der Nutzfrequenz (typischerweise 50 Hz oder 60 Hz) fließt, reduziert sich der Effektivwert des Stroms auf ca. 25 % des Bemessungsstroms $I_r$ des Filters. Die Tatsache, dass in der Querinduktivität $L_C$ nur 25 % des Bemessungsstroms $I_r$ fließen, hat zur Folge, dass die Gesamtenergie der Mehrfachwicklungsdrossel kleiner ist als bei einer herkömmlichen Filterauslegung, da $(0,25*I_r)$^2$*L_C$ gilt.

Die Annahme von Strömen im Querzweig, die etwa 25 % des Bemessungsstroms $I_r$ betragen, ist gültig für eine Auslegung des Filters auf einen gesamten THDI-Wert (Total Harmonic Distortion at Input, Gesamte harmonische Verzerrung am Eingang) von ca. 8 %, d.h. bei den aus einer solchen Auslegung resultierenden Werten für die Induktivitäten $L_A$, $L_{B\alpha}$, $L_{B\beta}$ und $L_C$ sowie für die zugehörige mit der Induktivität $L_C$ gekoppelte Kapazität. Bei einer anderen Auslegung des Netzfilters ändert sich der Strom in dem Querzweig entsprechend.

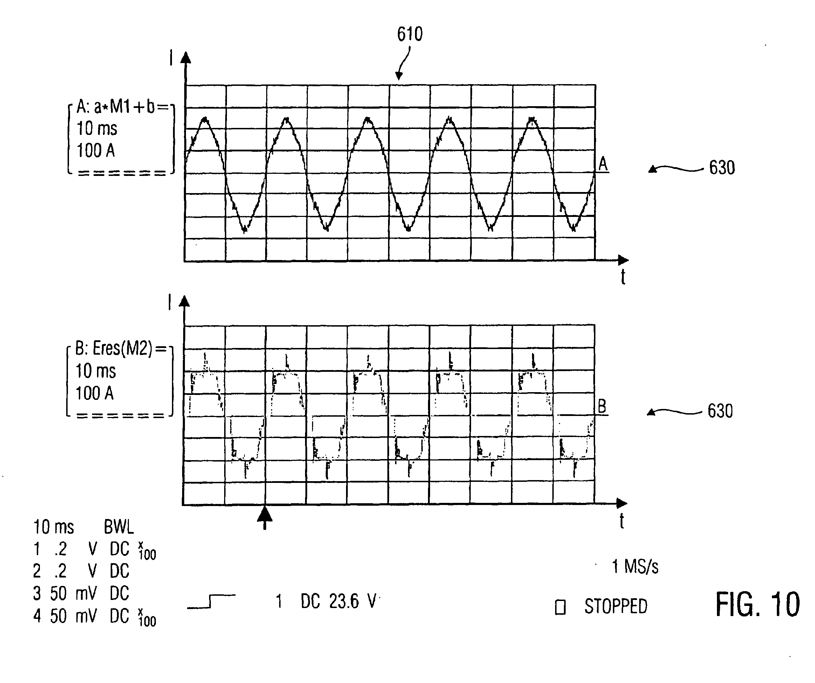

Grundsätzlich ist der Eingangsstrom des Oberschwingungsfilters nahezu sinusförmig, was dem Einsatzgebiet und der Aufgabe des Filters entspricht. Der Ausgangsstrom des Filters ist ein im Wesentlichen blockförmig verlaufender Strom, wie in Fig. 10 gezeigt. Aus der Kenntnis des Eingangsstroms und des Ausgangsstroms ergibt sich der Strom, der in dem Querzweig des Filters fließen muss. Der Stromfluss in dem Querzweig des Filters, d.h. durch die Induktivität $L_C$, setzt sich aus mehreren Anteilen zusammen. Einer dieser Anteile ist der durch die Kapazität in dem Querzweig verursachte kapazitive Strom bei der Nennfrequenz (typischerweise 50 Hz oder 60 Hz) des Filters, der über die Drossel $L_c$ in den damit gekoppelten Kondensator fließt. Der Effektivwert $I_{C\_50Hz}$ dieses Stromes kann mit Hilfe der unten angegebenen Formel (5) berechnet werden.

Zu diesem, in einem Leerlaufbetrieb des Filters noch sinusförmigen, Strom addiert sich dann unter Last der Differenzstrom zwischen Eingangsstrom und Ausgangsstrom des Filters, so dass es zu einem extrem nicht-sinusförmigen Stromverlauf kommt. Das bedeutet aber wiederum, dass die zu übertragende Energie des Filters während der lückenden Zeiten des Ausgangsstroms aus den in dem Querzweig des Netzfilters angeschlossenen Kapazitäten kommen muss. Dieser Sachverhalt ist die Konsequenz daraus, dass der Ausgangsstrom nahezu blockförmig ist.

Weiterhin ist bei der Auslegung des Filters zu beachten, dass die Kapazitäten in dem Querzweig nicht zu groß gewählt werden dürfen, um einen erhöhten kapazitiven Blindstrom in dem Querzweig zu vermeiden. Bei einer Auslegung des Oberschwingungsfilters auf einen THDI-Wert von 8% ergibt sich unter Verwendung von Werten für die Induktivitäten $L_A$, $L_{B\alpha}$, $L_{B\beta}$ und $L_C$, die für einen Bemessungsbetrieb berechnet sind, die zur Energieüberbrückung benötigte Kapazität aus dem gesamten Effektivwert des Stroms im Querzweig wie folgt:

$$I_q = 0,25*I_r \qquad\qquad (4)$$

$$I_{C\_50Hz} = 0,5*I_q = 0,125*I_r \qquad\qquad (5)$$

$$C_Y = I_{C\_50Hz}/(2*pi*f*U_{CY}) = 0,125*I_r/(2*pi*f*U_{CY}) \qquad\qquad (6)$$

$$C_\Delta = C_Y/3 \qquad\qquad (7)$$

Hierbei ist $I_q$ der Strom in dem Querzweig des Oberschwingungsfilters, $I_{C\_50Hz}$ der kapazitive Grundschwingungsstrom in den Filterkondensator bei einer Stern-Verschaltung der Kondensatoren, $C_Y$ die Kapazität der benötigten Kondensatoren in Sternschaltungen, $C_\Delta$ die Kapazität der benötigten Kondensatoren in Dreiecksschaltungen, $U_{CY}$ der Spannungsabfall über einem Kondensator in Sternschaltung in dem Querzweig und f die Nennfrequenz des Netzfilters.

Die errechnete Kapazität ist bei den vorher gemachten Aussagen ausreichend für die definierte Filterwirkung, da dieser Kapazitätswert gerade die Energie speichert, die während des Zeitintervalls, in dem der Ausgangsstrom "lückt", benötigt wird. Durch Erhöhung der Filterkapazitäten können zwar leichte Verbesserungen bei dem THDI-Wert erzielt werden, es treten jedoch andere Nachteile auf, die eine solche Vergrößerung des Kondensatorwerts zumeist als nicht wünschenswert erscheinen lassen.

Die Feinabstimmung zwischen den Einzelinduktivitäten der Mehrfachdrossel und der Größe des Kondensators sorgt für eine optimale Filterwirkung. Von dieser Feinabstimmung unberührt hingegen ist die prinzipielle Wirkung des Oberschwingungsfilters auch bei extrem ungünstig gewählten Induktivitätsverhältnissen untereinander bzw. im Zusammenhang mit dem angeschlossenen Filterkondensator. Das heißt, die eigentliche Erfindung, nämlich die Auslöschung von Flusskomponenten in dem dreiphasigen Eisenkern durch die geschickte Anordnung der Windungen auf dem dreiphasigen Kern, bleibt prinzipiell immer erhalten, und führt auch immer zu einer im Bauvolumen reduzierten Drossel. Das Gesamtbauvolumen und die benötigten Kapazitätswerte können aber durch eine optimierte Filteranpassung weiter reduziert werden. Hierzu können computergestützte Simulationen und sehr genaues Messequipment als Hilfsmittel dienen.

Bei genauer Betrachtung des Ein- und Ausgangsstroms des Filters, die in Fig. 10 beispielhaft dargestellt sind, wird ein weiterer Vorteil der erfindungsgemäßen Netzfilteranordnung deutlich. Der in einen angeschlossenen Verbraucher, bevorzugterweise ein Gerät mit interner B6-Gleichrichtung und Kondensatorglättung, fließende Strom sorgt durch seinen blockförmigen Verlauf für einen sehr geringen Rippelstrom in den internen Glättungskondensatoren des Verbrauchers. Dies führt, gerade bei Anschluss von Antriebssystemen, zu einer erhöhten Lebensdauer der eingebauten Elektrolytkondensatoren und somit zu einer längeren Lebensdauer des Geräts.

Durch eine Analyse eines erfindungsgemäßen Netzfilters 110, bei der insbesondere davon Gebrauch gemacht wurde, dass zu einer dreiphasigen Schaltungsanordnung mit bekannten Verfahren ein einphasiges Ersatzschaltbild konstruiert werden kann, können also die Vorteile einer erfindungsgemäßen Schaltung erkannt werden. Gebrauch gemacht wurde hierbei auch von der Möglichkeit, π-Schaltungen in T-Schaltungen umzuwandeln und umgekehrt.

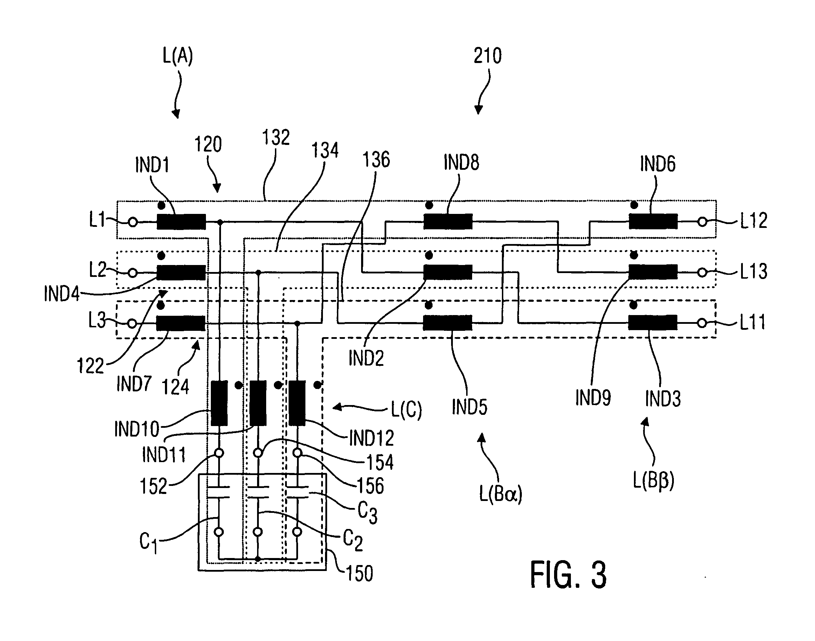

Fig. 3 zeigt ein Schaltbild eines erfindungsgemäßen dreiphasigen Netzfilters gemäß einem dritten Ausgangsbeispiel der vorliegenden Erfindung. Das Netzfilter ist in seiner Gesamtheit mit 210 bezeichnet. Aufbau und Funktionsweise des Netzfilters 210 unterscheiden sich nur unwesentlich von Aufbau und Funktionsweise des anhand von Fig. 2 gezeigten Netzfilters 110, so dass hier nur die unterschiedlichen Merkmale beschrieben werden. Insbesondere wird darauf hingewiesen, dass gleiche Bezugszeichen hier und auch in den folgenden Figuren auf gleiche Einrichtungen hinweisen.

Gezeigt ist in Fig. 3 insbesondere die geometrische Anordnung der Querinduktivitäten IND10, IND11, IND12 auf den Schenkeln des Filterkerns. Die zu dem ersten Filterzweig 120 gehörige Querinduktivität IND10 ist hierbei auf den ersten Schenkel 132 gewickelt. Die zu dem zweiten Filterzweig 122 gehörige Querinduktivität IND11 ist auf den zweiten Schenkel 134 des Filterkerns gewickelt. Die zu dem dritten Filterzweig 124 gehörige Querinduktivität IND12 ist auf den dritten Schenkel 136 des Filterkerns gewickelt. Eine solche Wickelung führt dazu, dass die Querinduktivitäten IND10, IND11, IND12 stark mit den eingangsseitigen Längsinduktivitäten IND1, IND4, IND7 des jeweiligen Filterzweigs verkoppelt sind. Da die Querinduktivitäten IND10, IND11, IND12 den gleichen Wicklungssinn wie die zugehörigen eingangsseitigen Längsinduktivitäten IND1, IND4, IND7 aufweisen, sind die eingangsseitigen Längsinduktivitäten IND1, IND4, IND7 sowie die Querinduktivitäten IND10, IND11, IND12 bezüglich eines Eingangsstroms, der an den Filtereingängen L1, L2, L3 in das Filter hineinfließt, in Serie geschaltet und stellen daher eine hohe Induktivität dar. Dies verringert die Ableitung des Eingangsstroms über den Querzweig und verringert so die Entstehung von Blindströmen in dem Netzfilter 210.

Die weitere Funktionsweise des Filters 210 ist gegenüber dem anhand von dem in Fig. 2 gezeigten Filter 110 unverändert, so dass auf eine Beschreibung hier verzichtet wird.

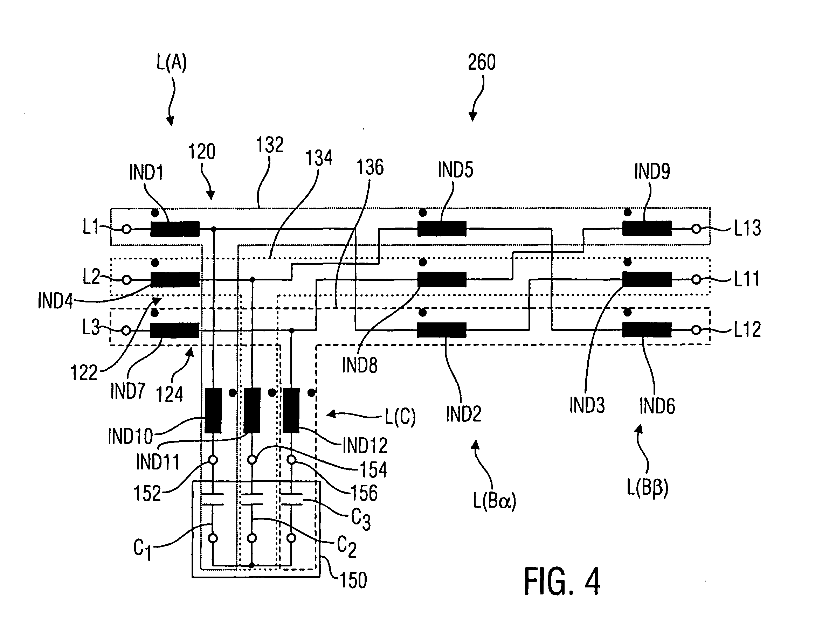

Fig. 4 zeigt ein Schaltbild eines erfindungsgemäßen dreiphasigen Netzfilters gemäß einem vierten Ausführungsbeispiel der vorliegenden Erfindung. Dieses ist wiederum sehr ähnlich den anhand der Figuren 2 und 3 gezeigten Filter, so dass auch hier nur die Unterschiede beschrieben sind. Als Bezug für eine Beschreibung wird hierbei das anhand von Fig. 3 gezeigte Netzfilter 210 verwendet. Das vorliegende Netzfilter ist mit 260 bezeichnet. Gleiche Bezugszeichen weisen wiederum auf gleiche Einrichtungen wie in den vorher beschriebenen Ausführungsbeispielen hin.

Die Struktur des Netzfilters 260 ist gegenüber dem Netzfilter 210 unverändert. Verändert ist lediglich die mechanische Position der ausgangsseitigen Induktivitäten IND2, IND5, IND8 sowie IND3, IND6, IND9 auf den Schenkeln 132, 134, 136 des Filterkerns. Die Reihenfolge der Induktivitäten bezogen auf den Stromfluss von dem Filtereingang zu dem Filterausgang ist bei dem Filter 260 unverändert gegenüber dem Filter 210. Somit liegen beispielsweise in dem ersten Filterzweig 120 Induktivitäten IND1, IND2 und IND3 in eben dieser Reihenfolge zwischen dem Filtereingang L1 und dem Filterausgang L11. Ähnliches gilt für den zweiten Filterzweig 122 und dem dritten Filterzweig 124. Verändert ist bei dem Netzfilter 260 allerdings gegenüber dem Netzfilter 210 die mechanische Anordnung der Induktivitäten auf den Filterschenkeln. In unveränderter Weise befinden sich allerdings die Induktivitäten IND1 und IND10 auf dem ersten Filterschenkel 132, die Induktivitäten IND4 und IND11 auf dem zweiten Filterschenkel und die Induktivitäten IND7 und IND12 auf dem dritten Filterschenkel. Geändert ist hingegen die Anordnung der ausgangsseitigen Induktivitäten. Die Induktivität IND2 des ersten Filterzweigs befindet sich nunmehr auf dem dritten Filterschenkel 136 und die Induktivität IND3 des ersten Filterzweigs 120 auf dem zweiten Filterschenkel 134. Weiterhin verändert ist die Anordnung der Induktivität IND5 des zweiten Filterzweiges 122, die bei dem Filter 260 auf den ersten Schenkel 132 gewickelt ist, und der Induktivität IND6 des zweiten Filterzweigs 122, die nunmehr auf dem dritten Schenkel 136 gewickelt ist. Schließlich ist die Induktivität IND8 des dritten Filterzweigs 124 auf den zweiten Schenkel 134 gewickelt und die Induktivität IND9 auf den ersten Schenkel 132.

Eine veränderte mechanische Anordnung der Induktivitäten auf den Filterschenkeln lässt die Eigenschaften des Netzfilters 260 im Wesentlichen unverändert, stellt aber eine weitere Ausführungsform dar, die je nach Gegebenheiten mechanisch vorteilhaft sein kann.

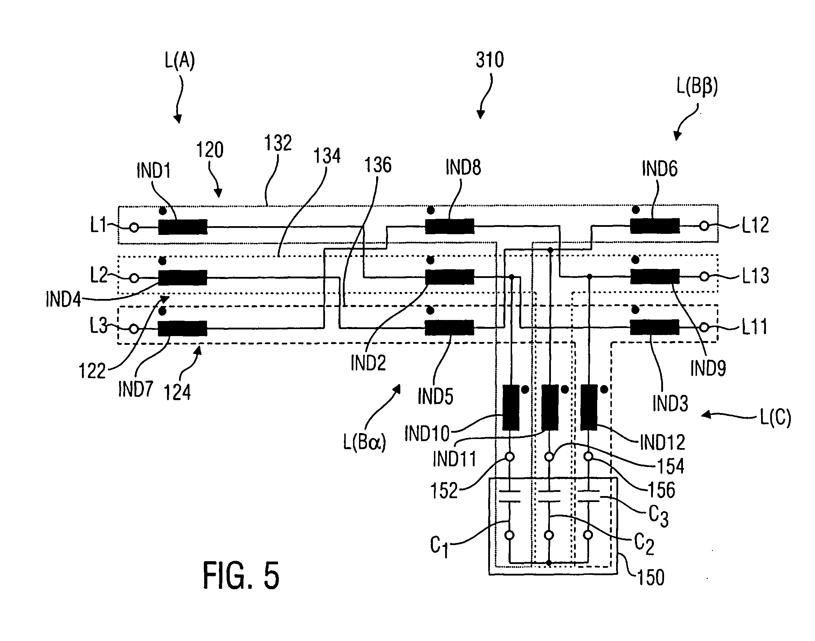

Fig. 5 zeigt ein Schaltbild eines erfindungsgemäßen dreiphasigen Netzfilters gemäß dem fünften Ausführungsbeispiel der vorliegenden Erfindung. Das gezeigte Netzfilter ist in seiner Gesamtheit mit 310 bezeichnet. Auch das Netzfilter 310 ist bezüglich Aufbau und Funktionsweise dem anhand von Fig. 3 gezeigten Netzfilter 210 sehr ähnlich. Somit wird hier nur auf die Unterschiede eingegangen. Gleiche Bezugszeichen bezeichnen wiederum gleiche Einrichtungen.

Bei dem Netzfilter 310 erfolgt die Ankopplung des Querzweigs nicht zwischen der ersten und zweiten Induktivität IND1, IND2; IND4, IND5; IND7, IND8 eines jeden Filterzweigs (vom Filtereingang aus gezählt), sondern zwischen der zweiten und dritten Induktivität IND2, IND3; IND5, IND6; IND8, IND9. Zur näheren Erläuterung soll hier der erste Filterzweig 120 betrachtet werden. Die Querinduktivität IND10 des ersten Filterzweigs 120 ist nunmehr zwischen Induktivität IND2 und Induktivität IND3 angekoppelt. Bezüglich der weiteren Verschaltung, insbesondere der Verteilung der Induktivitäten auf die Schenkel bestehen keine Unterschiede zwischen den Netzfiltern 210 und 310.

Die Netzfilter 210 und 310 unterscheiden sich bezüglich ihrer grundsätzlichen Eigenschaften nicht wesentlich. Unterschiede können sich jedoch bei der Dimensionierung, d.h. der Auslegung der Induktivitäten bzw. Kapazitäten ergeben. Je nach den Anforderungen und den mechanischen Gegebenheiten kann somit eine Filteranordnung 210 gemäß Fig. 3 oder eine Filteranordnung 310 gemäß Fig. 5 vorteilhafter sein.

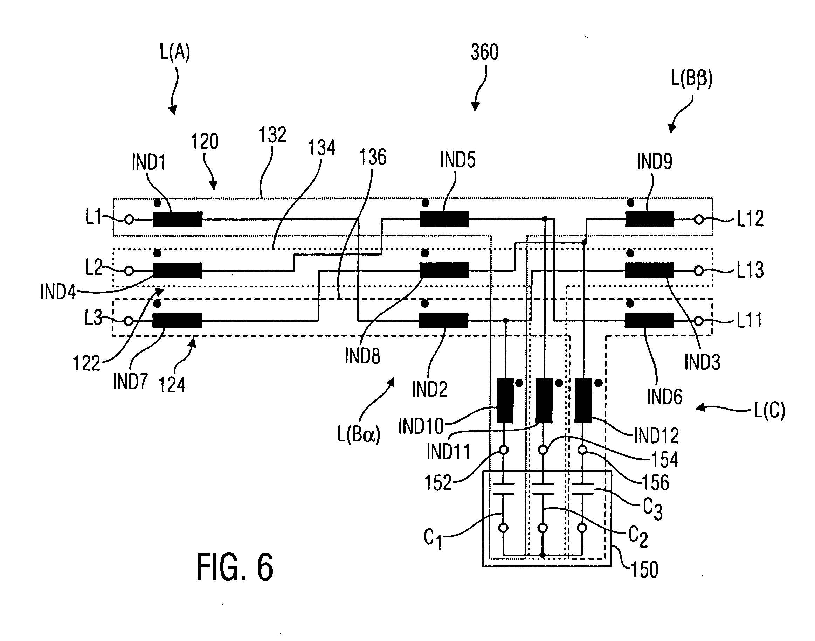

Fig. 6 zeigt ein Schaltbild eines erfindungsgemäßen dreiphasigen Netzfilters gemäß einem sechsten Ausführungsbeispiel der vorliegenden Erfindung. Das Filter entspricht von seinem prinzipiellen Aufbau und von seiner Funktionsweise den anhand der Figuren 2 bis 5 gezeigten Filtern, so daß hier wiederum auf die dortige Beschreibung verwiesen wird. Gleiche Bezugszeichen kennzeichnen auch hier gleiche Einrichtungen wie in den vorher beschriebenen Netzfiltern. Das anhand von Fig. 6 gezeigte Netzfilter ist in seiner Gesamtheit mit 360 bezeichnet. Es entspricht von der Verteilung der Induktivitäten auf die Filterkerne dem anhand von Fig. 4 gezeigten Netzfilter 260. Die Querzweige zweigen jedoch, ähnlich wie bei dem anhand von Fig. 5 beschriebenen Netzfilter 310, zwischen der zweiten und dritten Induktivität IND2, IND3; IND5, IND6; IND8, IND9 eines jeden Filterzweigs 120, 122, 124 ab.

Eine solche Ausführungsform stellt wiederum eine Alternative zu dem anhand von Fig. 4 gezeigten Filter 260 sowie zu dem anhand von Fig. 5 gezeigten Filter 310 dar. Die Eigenschaften sind im Wesentlichen unverändert, jedoch ist wiederum eine andere Dimensionierung der Induktivitäten und Kapazitäten erforderlich.

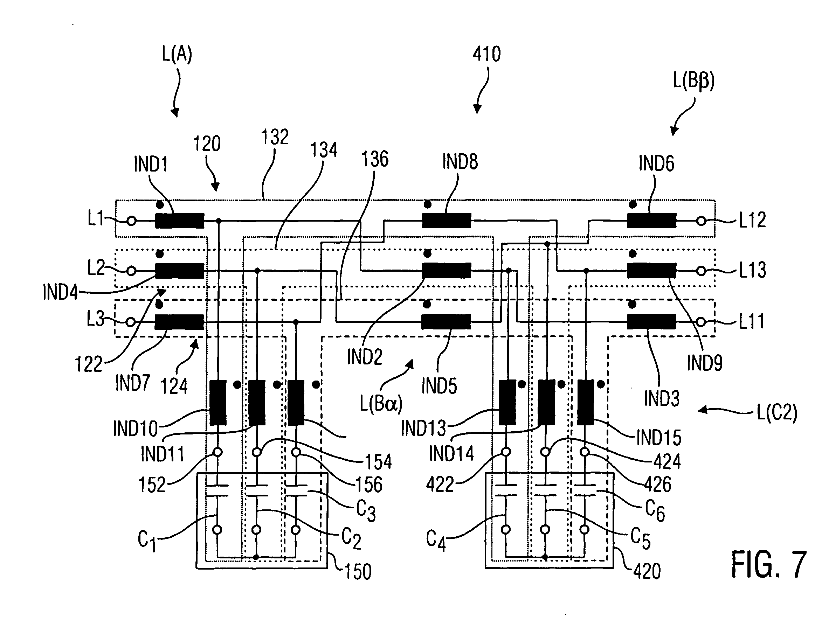

Fig. 7 zeigt ein Schaltbild eines erfindungsgemäßen dreiphasigen Netzfilters gemäß einem siebten Ausführungsbeispiel der vorliegenden Erfindung. Das Filter ist in seiner Gesamtheit mit 410 bezeichnet und basiert auf dem anhand von Fig. 3 gezeigten Filter 210. Gleiche Bezugszeichen kennzeichnen wiederum gleiche Einrichtungen. Merkmale des Filters 410, die gegenüber dem Filter 210 unverändert sind, werden hier nicht erneut beschrieben. Vielmehr wird auf die Beschreibung des Filters 210 bzw. des Filters 110 verwiesen.

Das Filter 410 ist gegenüber dem Filter 210 ergänzt, indem ein zweiter Querzweig eingeführt ist. Dieser umfasst die Induktivitäten IND13, IND14 und IND15 sowie eine zweite kapazitive Energiespeichereinrichtung 420, die drei Kapazitäten C4, C5, C6 umfasst. Die zweite kapazitive Energiespeichereinrichtung 420 weist einen ersten Anschluss 422, einen zweiten Anschluss 424 sowie einen dritten Anschluss 426 auf. Im Übrigen ist anzumerken, dass die Induktivitäten des ersten Querzweigs nun zusammenfassend als L(C1) bezeichnet sind, während die Induktivitäten IND13, IND14 und IND15 des zweiten Querzweigs zusammenfassend mit L(C2) bezeichnet sind. Die Induktivität IND13 des zweiten Querzweigs ist mit dem Knotenpunkt zwischen der zweiten Induktivität IND2 und der dritten Induktivität IND3 des ersten Filterzweigs 120 sowie mit dem ersten Anschluss 422 der zweiten kapazitiven Energiespeichereinrichtung 420 verbunden. Die Induktivität IND13 des zweiten Querzweigs des ersten Filterzweigs 120 ist auf den ersten Schenkel 132 gewickelt. Der Wickelsinn ist hierbei gleich wie der aller anderen Induktivitäten.

In analoger Weise wie die Induktivität IND13 des ersten Filterzweigs sind auch die Induktivitäten IND14 und IND15 des zweiten und dritten Filterzweigs verschaltet und auf den zweiten bzw. dritten Schenkel 134, 136 des dreiphasigen Filterkerns gewickelt. Die Details der Verschaltung sind der Fig. 7 zu entnehmen.

Ein Netzfilter 410, das einen zweiten Querzweig aufweist, kann ausgelegt werden, um eine bessere Filterwirkung als ein Netzfilter mit nur einem Filterzweig zu erzielen. Insbesondere können die Querzweige zur Unterdrückung von zwei unerwünschten Frequenzen dimensioniert werden. Insgesamt gesehen bestehen mehr Freiheitsgrade beim Filterentwurf, da das Filter von einer höheren Filterordnung ist. Dadurch erhöht sich auch der Aufwand zur Realisierung eines Netzfilters mit zwei Querzweigen, da zusätzliche Querinduktivitäten IND13, IND14, IND15 sowie zusätzliche Kapazitäten C4, C5, C6 erforderlich sind. Je nach den Anforderungen ist es somit zweckmäßig, ein Filter mit nur einem Querzweig oder ein Filter 410 mit zwei Querzweigen zu verwenden.

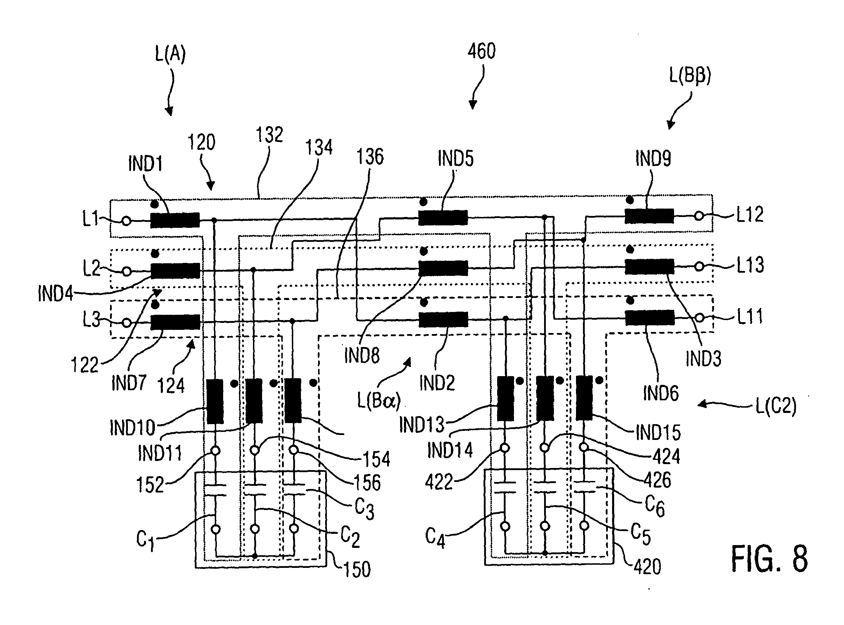

Fig. 8 zeigt ein Schaltbild eines erfindungsgemäßen dreiphasigen Netzfilters gemäß einem achten Ausführungsbeispiel der vorliegenden Erfindung. Dieses Filter entspricht im Wesentlichen dem anhand von Fig. 7 gezeigten Netzfilter 410, wobei die Induktivitäten im Längszweig wie bei dem anhand von Fig. 4 gezeigten Filter 260, anstatt wie bei dem anhand von Fig. 3 gezeigten Filter 210, verschaltet sind. Das Filter 460 stellt somit lediglich eine weitere Alternative dar, die je nach den Anforderungen und den mechanischen Gegebenheiten verwendet werden kann.

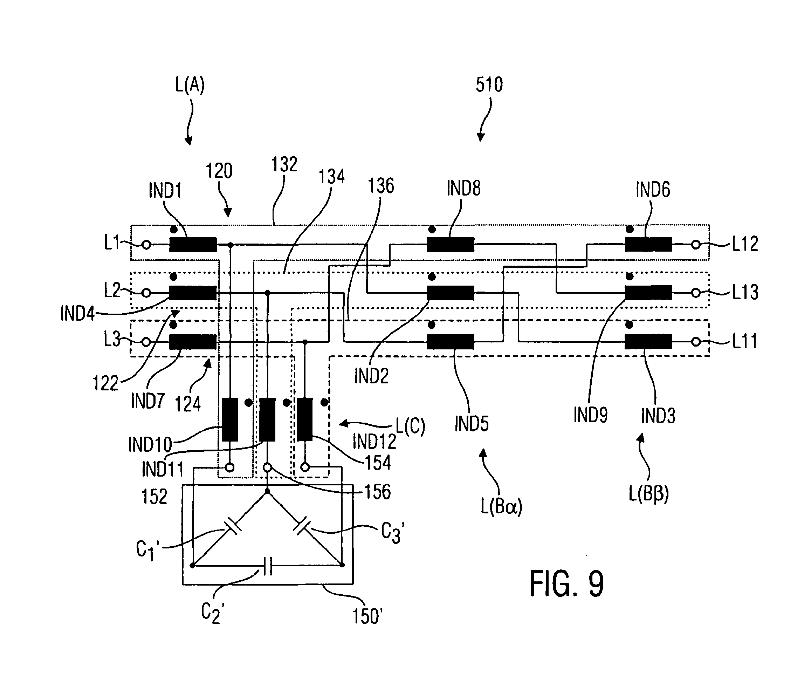

Fig. 9 zeigt ein Schaltbild eines erfindungsgemäßen dreiphasigen Netzfilters gemäß einem neunten Ausführungsbeispiel der vorliegenden Erfindung, das in seiner Gesamtheit mit 510 bezeichnet ist. Das Filter entspricht im Wesentlichen den anhand der Figuren 3 und 4 gezeigten Netzfiltern 210 und 260, so dass unveränderte Einrichtungen nicht mehr neu beschrieben werden. Vielmehr wird auf die vorhergehende Beschreibung verwiesen. Insbesondere weisen auch gleiche Bezugszeichen auf gleiche Einrichtungen hin. Das Filter 510 ist gegenüber dem Filter 210 insofern verändert, als die Energiespeichereinrichtung 150' hier eine Dreiecksschaltung von Kondensatoren C1', C2' und C3' umfasst. Eine Dreiecksschaltung von Kondensatoren bietet gegenüber einer Sternschaltung, wie sie bei dem Netzfilter 210 gezeigt ist, den Vorteil, dass die Kondensatoren eine geringere Kapazität aufweisen müssen. Allerdings ist es notwendig, dass die Kondensatoren einer Dreiecksschaltung eine höhere Spannungsfestigkeit besitzen als die Kondensatoren einer Sternschaltung. Schließlich ist es bei der Verwendung einer Dreiecksschaltung auch nicht möglich, einen Anschluss der Kondensatoren zu erden.

Es ist somit wiederum von der Anwendung und den Anforderungen abhängig, ob eine Sternschaltung von Kondensatoren oder eine Dreiecksschaltung von Kondensatoren vorteilhafter ist.

Die gezeigten Netzfilter können in einem weiten Umfang verändert werden, ohne von dem Kerngedanken der Erfindung abzuweichen. So ist es beispielsweise möglich, in jedem Filterzweig ausgangsseitig nur eine Längsinduktivität (z.B. IND2, IND5 und IND8) zu verwenden und auf die zweite Induktivität (z.B. IND3, IND6, IND9) zu verzichten. Zwar ist bei einem solchen Filter eine vollständige Symmetrie nicht mehr gewährleistet, jedoch weist es immer noch Vorteile gegenüber einem herkömmlichen Filter auf, in dem alle Induktivitäten eines Filterzweigs auf dem gleichen Schenkel des Filterkerns angeordnet sind.

Weiterhin ist es möglich, die Querinduktivitäten IND10, IND11, IND12 sowie gegebenenfalls IND13, IND14, IND15 eines Filterzweigs auf einen anderen Schenkel 132, 134, 136 des Filterkerns aufzuwickeln als die eingangsseitige Induktivität IND1, IND2, IND3. Eine solche Vertauschung bringt einen weiteren Freiheitsgrad bei dem Entwurf und der Auslegung eines Netzfilters.

Im Übrigen ist es auch problemlos möglich, ein Netzfilter durch weitere Filterstufen zu ergänzen, und so ein Filter höherer Ordnung zu erhalten. Ein solches ist zwar aufwendiger in der Herstellung, bietet aber bei geeigneter Auslegung eine verbesserte Filtercharakteristik. Dies kann erforderlich sein, wenn die Anforderungen an die Filterwirkung hoch sind.

Weiterhin ist es möglich, zusätzliche Kapazitäten oder Induktivitäten zu dem Filter hinzuzufügen. Beispielsweise können an einem Verbindungsknoten zwischen zwei Längsinduktivitäten, die zwischen dem Filtereingang und dem Filterausgang liegen, mehrere Querzweige angekoppelt sein. Ein Querzweig kann hierbei nicht nur eine Serienschaltung aus einer Induktivität und einem kapazitiven Energiespeicherelement umfassen, sondern auch eine Kapazität an sich. Dies kann hilfreich sein, um hochfrequente Störungen zu unterdrücken, vorausgesetzt die Kapazität ist so ausgelegt, dass ein kapazitiver Blindstrom bei der Nennfrequenz des Netzfilters hinreichend klein ist.

Weiterhin kann das Filter Schalteinrichtungen umfassen, die es ermöglichen, das Filter an verschiedene Betriebszustände anzupassen. So kann es vorteilhaft sein, Querkapazitäten abzuschalten. Auch kann es wünschenswert sein, einzelne Induktivitäten zu überbrücken. Damit ist der Spannungsabfall über dem Filter bzw. ein durch das Filter erzeugter Blindstromanteil beeinflussbar. Dies kann vorteilhaft sein, wenn sehr starke Lastwechsel auftreten können oder das Filter für eine Vielzahl von Betriebsfällen konfigurierbar sein soll.

Schließlich besteht eine hohe Flexibilität bei der Auslegung des mehrphasigen Filterkerns. Prinzipiell können alle verfügbaren Kerntypen verwendet werden, beispielsweise Kerne aus Eisen oder Eisenpulver.

Fig. 10 zeigt ein Oszillogramm der Stromverläufe an dem Netzeingang und dem Ausgang eines erfindungsgemäßen Netzfilters gemäß dem in Fig. 2 bzw. 3 gezeigten Filter. Das Oszillogramm ist in seiner Gesamtheit mit 610 bezeichnet. Es zeigt einen ersten Kurvenverlauf 620, der den Stromverlauf an dem Eingang des erfindungsgemäßen Netzfilters darstellt. An der Abszisse t ist die Zeit eingetragen, während die Ordinate I den Eingangsstrom zeigt. In ähnlicher Weise zeigt das Oszillogramm einen zweiten Kurvenverlauf 630, der den Ausgangsstrom an dem Ausgang des erfindungsgemäßen Netzfilters darstellt. Wiederum ist an der Abszisse t die Zeit eingetragen, während die Ordinate I den Strom zeigt.

Für die Messung ist ein erfindungsgemäßes Netzfilter mit einer dreiphasigen Last beschaltet, die eine interne B6-Gleichrichtung und eine Kondensatorglättung aufweist. Der Eingangsstrom des Netzfilters, der durch den Signalverlauf 620 beschrieben wird, ist im Wesentlichen sinusförmig. Der Ausgangsstrom, der durch den Kurvenverlauf 630 beschrieben wird, ist hingegen näherungsweise blockförmig. Der Stromverlauf an dem Filterausgang zeigt einen sehr steilen Anstieg und einen sehr steilen Abfall des Stroms, während der Strom für große Stromwerte nahezu konstant ist. In der Umgebung des Nulldurchgangs ändert sich der Strom über der Zeit nur gering, so dass der Stromfluss für ein Zeitintervall von etwa 2 ms (bei einer Periodendauer von 20 ms) nahezu konstant ist.

Es soll im Übrigen erwähnt werden, dass der gezeigte Stromverlauf eine Periodendauer von etwa 20 ms aufweist, was einer Frequenz von 50 Hz entspricht. Die Amplitude des Stroms beträgt etwa 250 Ampere.

Es zeigt sich, dass der in den angeschlossenen Verbraucher fließende Strom durch seinen blockförmigen Verlauf zu einem sehr geringen Rippelstrom in den internen Kondensatoren des Verbrauchers führen kann. Dies kann zu einer erhöhten Lebensdauer der Elektrolytkondensatoren in dem Verbraucher und somit zu einer verlängerten Lebensdauer des angeschlossenen Verbrauchergeräts führen.

Zusammenfassend lässt sich festhalten, dass die vorliegende Erfindung einen passiven Oberschwingungsfilter beschreibt, der aus einer Kombination einer intelligent verschalteten Mehrfachwicklungsdrossel und mehrerer elektrischer Kondensatoren besteht, und der zur signifikanten Reduzierung von Stromoberschwingungen am Eingang nichtlinearer Verbraucher dient.

Die durch nichtlineare Verbraucher erzeugten Netzrückwirkungen führen vielfach zu Störungen in dem öffentlichen Versorgungsnetz. Der vorstehend beschriebene passive Oberschwingungsfilter dient zur signifikanten Reduzierung der Stromoberschwingungen von nichtlinearen Verbrauchern, im Speziellen von elektronischen Geräten mit interner B2 oder B6 Gleichrichterschaltung und anschließender Glättung durch Kondensatoren oder durch eine Kombination von Kondensatoren und Drosseln. Solche elektronischen Geräte werden vorzugsweise in elektrischen Antriebssystemen verwendet. Die Besonderheit der Erfindung liegt in der Kombination aus einer Mehrfachwicklungsdrossel mit einzigartiger Verschaltung der Wicklungen untereinander und einer Anschaltung von Kondensatoren. Die dadurch erreichte nahezu sinusförmige Stromaufnahme an dem Eingang des Netzfilters bei Ankopplung von nichtlinearen Verbrauchern an dem Filterausgang wird mit der erfindungsgemäßen speziellen Technik mit einem Minimum an Bauvolumen und Verlustleistung erreicht. Die erfindungsgemäße geschickte Verschaltung verschiedener Wickelungen auf einem magnetischen Kern nutzt die magnetischen Eigenschaften der Drossel durch Aufhebung von verschiedenen Flusskomponenten in Verbindung mit der aus Kondensatoren gelieferten Energie. Die daraus resultierende sinusförmige Stromaufnahme an dem Filtereingang ist im Wesentlichen lastunabhängig.

Das Oberschwingungsfilter wird zwischen die versorgende Netzspannung und das betroffene elektronische Gerät geschaltet, und wird daher auch als Front-End-Oberschwingungsfilter bezeichnet. Eine eingangsseitige Parallelschaltung von mehreren Verbrauchern ist unter bestimmten Voraussetzungen durchaus möglich und wird als Gruppenkompensation bzw. Gruppenfilter bezeichnet.

Das Oberschwingungsfilter besteht aus einer Mehrfachwicklungsdrossel, bei der alle Wicklungen im gleichen Wickelsinn gewickelt sind und über die Phasen auf die verschiedenen Schenkel eines magnetischen dreiphasigen Eisenkerns verteilt sind. Dabei ist immer mindestens eine Wicklung einer Phase (z.B. der Phase L1) auf einen anderen Schenkel gewickelt als die restlichen Wicklungen. Die angeschalteten Kondensatoren können mindestens an einem oder mehreren Verknüpfungspunkten der Wicklungen angeschlossen werden.

Die resultierende Filterschaltung verringert erheblich Stromoberschwingungen am Eingang des Filters und sorgt gleichzeitig für einen geglätteten Gleichstrom nach dem Gleichrichter. Dadurch wird ein stark reduzierter Rippelstrom in den nachgeschalteten Glättungskondensatoren erzielt.

Nachteile bekannter Oberschwingungsfilter werden bei einem erfindungsgemäßen Netzfilter auf ein Minimum reduziert. Die technischen Merkmale werden gegenüber den derzeitigen Lösungen erheblich verbessert. So ist ein erfindungsgemäßes Oberschwingungsfilter durch sein geringes Bauvolumen, seine geringe Verlustleistung und geringe Kosten ein attraktives und marktfähiges Filter zur Verringerung von Stromoberschwingungen.

Die Verteilung der einzelnen Wicklungen auf mindestens zwei Schenkel oder mehr eines dreiphasigen magnetischen Eisenkerns führt zur Reduzierung des effektiven Spannungsabfalls im Längszweig des Filters. Weiterhin erreicht man durch die geschickte Verteilung der Wicklungen auf mindestens einen oder mehrere Schenkel des dreiphasigen Eisenkerns eine Auslöschung einzelner Flusskomponenten. Dadurch verringert sich nicht nur der Spannungsabfall am Längszweig des Filters, sondern es können auch die im Querzweig angeschalteten Kondensatoren wesentlich verkleinert werden, da die aus den Kondensatoren zu liefernde Energie sinkt. Das wiederum führt zu geringerem kapazitiven Blindstrom im Leerlauf oder unter Teillastbedingungen. Ein Abschalten der Kapazitäten ist in den meisten Anwendungen nicht mehr nötig. Durch computergestützte Berechnung und messtechnisch gewonnene Erkenntnisse können die Werte der einzelnen Induktivitäten der Mehrfachwicklungsdrossel genau optimiert und aufeinander abgestimmt werden. Daraus ergibt sich ein kleinerer Wicklungsaufwand und somit geringere Verluste. Durch die genannten Berechnungen kann außerdem das Verhältnis der Einzelinduktivitäten zu den angeschalteten Kondensatoren genau ermittelt werden, um auch hier ein Optimum zu finden und die Schwingneigung des Filtersystems sehr gering zu halten.

Ein Filter gemäß den Figuren 2 oder 3 bzw. gemäß den Figuren 4 bis 9 weist mindestens eine Wicklung pro Phase auf einem anderen Schenkel des dreiphasigen magnetischen Kerns auf als die restlichen Wicklungen und hat mindestens einen angeschalteten Kondensator pro Phase. Die Kondensatoren können in Stern oder in Dreieck verdrahtet sein. Bei einem besonders vorteilhaften Filter haben alle Wicklungen den gleichen Wickelsinn. Dabei kann der Wickelsinn bei allen Wicklungen positiv oder negativ sein. Dies ändert nicht die eigentliche Funktion des Prinzips der Erfindung. Die Wicklungen haben auf jedem Schenkel, also auch innerhalb der drei Phasen L1, L2, L3 den gleichen Wickelsinn. Eine Mehrfachwicklungsdrossel gemäß Fig. 3 hat mindestens vier oder mehr Wicklungen pro Phase, wobei mindestens eine Wicklung (oder mehr) pro Phase auf einen anderen Schenkel des dreiphasigen Eisenkerns gewickelt ist als die restlichen Wicklungen. In anderen Worten, mindestens eine Wicklung pro Phase liegt auf einem Schenkel des dreiphasigen Eisenkerns, der definitionsgemäß zu einer anderen Phase gehört. Für den Eisenkern kann statt Eisen auch Eisenpulver oder ein beliebiges anderes Material verwendet werden.

Die Kondensatoren können auf der freien Seite der Induktivität im Querzweig, an jedem Verknüpfungspunkt zwischen den Induktivitäten im Längszweig und Querzweig angeschlossen werden. Es können Kondensatoren entweder nur einmal pro Phase oder mehrmals pro Phase angeschlossen werden, wenn mehrere Verknüpfungspunkte vorhanden sind. Hierzu sollte angemerkt werden, dass zwei Verknüpfungspunkte minimal immer vorhanden sind. Weiterhin können die Kondensatoren auch an alle zur Verfügung stehenden Induktivitäten der Querzweige angeschlossen werden. Die Kondensatoren können entweder im Stern oder im Dreieck an die im Querzweig liegenden Induktivitäten angeschlossen sein.

Die Verschaltung der Wicklungen im gleichen Wickelsinn ergibt nur dann einen technischen Vorteil, wenn im Inneren des magnetischen Kerns eine Auslöschung-von Flusskomponenten stattfindet. Dies sind Flusskomponenten, die vorwiegend höherfrequente Anteile (mit einer Frequenz höher als die Frequenz der versorgenden Netzspannung des Filters) enthalten. Der mechanische dreiphasige Aufbau des magnetischen Kerns wird hierbei zusammen mit der Phasenverschiebung der drei Phasen L1, L2 und L3 ausgenutzt.

**Patentansprüche**

1. Dreiphasen-Oberschwingungs-Netzfilter (110; 210; 260; 310; 360; 410; 460; 510) mit folgenden Merkmalen:

einem ersten Filterzweig (120) zwischen einem ersten Filtereingang (FE1; L1) und einem ersten Filterausgang (FA1; L11), wobei der erste Filterzweig (120) eine erste Serienschaltung von drei Induktivitäten (IND1, IND2, IND3) aufweist, die zwischen den ersten Filtereingang (L1) und den ersten Filterausgang (L13) geschaltet sind, und die auf drei verschiedene Schenkel (132, 134, 136) eines dreischenkligen Filterkerns (130) gewickelt sind;
einem zweiten Filterzweig (122) zwischen einem zweiten Filtereingang (FE2; L2) und einem zweiten Filterausgang (FA2; L12), wobei der zweite Filterzweig (122) eine zweite Serienschaltung von drei Induktivitäten (IND4, IND5, IND6) aufweist, die zwischen den zweiten Filtereingang (L2) und den zweiten Filterausgang (L12) geschaltet sind, und auf drei verschiedene Schenkel (132, 134, 136) des dreischenkligen Filterkerns (130) gewickelt sind; und
einem dritten Filterzweig (124) zwischen einem dritten Filtereingang (L3) und einem dritten Filterausgang (L13), wobei der dritte Filterzweig (124) eine dritte Serienschaltung von drei Induktivitäten (IND7, IND8, IND9) aufweist, die zwischen den dritten Filtereingang (L3) und den dritten Filterausgang (L13) geschaltet sind, und die auf drei verschiedene Schenkel des dreischenkligen Filterkerns gewickelt sind,
wobei Eingangsinduktivitäten (IND1, IND4, IND7) oder Ausgangsinduktivitäten (IND3, IND 6, IND9) der drei Filterzweige (120, 122, 124) auf unterschiedliche Schenkel (132, 134, 136) des dreischenkligen Filterkerns gewickelt sind;
wobei der erste Filterzweig (120) eine erste Querinduktivität (IND10) umfasst;
wobei der zweite Filterzweig (122) eine zweite Querinduktivität (IND11) umfasst;
wobei der dritte Filterzweig (124) eine dritte Querinduktivität (IND12) umfasst;
wobei ein Knoten, an dem zwei Induktivitäten (IND1, IND2; IND2, IND3) der ersten Serienschaltung verbunden sind, über die erste Querinduktivität (IND10) mit einem ersten Anschluss (152) einer kapazitiven Energiespeichereinrichtung (150) gekoppelt ist;
wobei ein Knoten, an dem zwei Induktivitäten (IND4, IND5; IND5, IND6) der zweiten Serienschaltung verbunden sind, über die zweite Querinduktivität (IND11) mit einem zweiten Anschluss (154) der kapazitiven Energiespeichereinrichtung (150) gekoppelt ist;
wobei ein Knoten, an dem zwei Induktivitäten (IND7, IND8; IND8, IND9) der dritten Serienschaltung verbunden sind, über die dritte Querinduktivität (IND12) mit einem dritten Anschluss (156) der kapazitiven Energiespeichereinrichtung (150) gekoppelt ist; und
wobei die drei Querinduktivitäten (IND10, IND11, IND12) auf den drei Schenkeln des dreischenkligen Filterkerns angeordnet sind.

2. Dreiphasen-Oberschwingungs-Netzfilter (110; 210; 260; 310; 360; 410; 460; 510) gemäß Anspruch 1, wobei das Dreiphasen-Netzfilter ausgelegt ist, um Nutz-Wechselströme mit einer vorgegebenen Frequenz von dem ersten Filtereingang (FE1; L1) zu dem ersten Filterausgang (FA1; L11) und von dem zweiten Filtereingang (FE2; L2) zu dem zweiten Filterausgang (FA2; L12) weiterzuleiten, um Störströme mit einer anderen als der vorgegebenen Frequenz, die an dem ersten Filterausgang (FA1; L11) auftreten, an dem ersten Filtereingang (FE1; L1) zu dämpfen, oder um Störströme, die an dem zweiten Filterausgang (FA2; L12) auftreten, an dem zweiten Filtereingang (FE2; L2) zu dämpfen.

3. Dreiphasen-Oberschwingungs-Netzfilter (110; 210; 260; 310; 360; 410; 460; 510) gemäß Anspruch 1 oder 2, bei dem der erste Filterzweig (120) eine erste Induktivität (IND1), die zwischen den ersten Filtereingang (L1) und einen ersten Knoten geschaltet ist, eine zweite Induktivität (IND2), die zwischen den ersten Knoten und den ersten Filterausgang (L11) geschaltet ist, sowie eine dritte Induktivität (IND10), die mit dem ersten Knoten gekoppelt ist, um einen ersten Querzweig des Mehrphasen-Netzfilters zu bilden, umfasst; und
bei dem der zweite Filterzweig (122) eine vierte Induktivität (IND4), die zwischen den zweiten Filtereingang und einen zweiten Knoten geschaltet ist, eine fünfte Induktivität (IND5), die zwischen den zweiten Knoten und den zweiten Filterausgang (L12) geschaltet ist, sowie eine sechste Induktivität (IND11), die mit dem zweiten Knoten gekoppelt ist, um einen zweiten Querzweig des Mehrphasen-Netzfilters zu bilden, umfasst;
wobei die zweite Induktivität (IND2) und die vierte Induktivität (IND4) auf den gleichen Schenkel (134) des dreischenkligen Filterkerns (130) gewickelt sind.

4. Dreiphasen-Oberschwingungs-Netzfilter (110; 210; 260; 310; 360; 410; 460; 510) gemäß Anspruch 3, bei dem die dritte Induktivität (IND10) mit einem ersten Anschluss (152) einer kapazitiven Energiespeichereinrichtung (150) gekoppelt ist, und bei dem die sechste Induktivität (IND11) mit einem zweiten Anschluss (154) der kapazitiven Energiespeichereinrichtung (150) gekoppelt ist.

5. Mehrphasen-Oberschwingungs-Netzfilter (110; 210; 260; 310; 360; 410; 460; 510) gemäß Anspruch 1 oder 2; bei dem der erste Filterzweig (120) einen ersten Knoten, der mit zwei Induktivitäten (IND1, IND2) der Serienschaltung von Induktivitäten des ersten Filterzweigs (120) gekoppelt ist, umfasst;
bei dem der zweite Filterzweig (122) einen zweiten Knoten, der mit zwei Induktivitäten (IND4, IND5) der Serienschaltung von Induktivitäten des zweiten Filterzweigs gekoppelt ist, umfasst; und
wobei der erste Knoten mit einem ersten Anschluss (152) einer kapazitiven Energiespeichereinrichtung (150) gekoppelt ist, und wobei der zweite Knoten mit einem zweiten Anschluss (154) der kapazitiven Energiespeichereinrichtung (150) gekoppelt ist.

6. Dreiphasen-Oberschwingungs-Netzfilter (110; 210; 260; 310; 360; 410; 460; 510) gemäß einem der Ansprüche 1 bis 5, bei dem die Induktivitäten (IND1, IND2, IND3, IND4, IND5, IND6, IND7, IND8, IND9) der ersten, zweiten und dritten Serienschaltung einen gleichen Wickelsinn aufweisen.

7. Dreiphasen-Oberschwingungs-Netzfilter (110; 210; 260; 310; 360; 410; 460; 510) gemäß einem der Ansprüche 1 bis 6, bei der die Serienschaltungen hinsichtlich Windungszahlen der Induktivitäten (IND1, IND2, IND3, IND4, IND5, IND6, IND7, IND8, IND9) und hinsichtlich einer Verteilung der Induktivitäten (IND1, IND2, IND3, IND4, IND5, IND6, IND7, IND8, IND9) auf die Schenkel (132, 134, 136) des mehrschenkligen Filterkerns (130) so ausgelegt ist, dass ein magnetischer Fluss in einem Schenkel (132, 134, 136) des mehrschenkligen Filterkerns, bezogen auf eine Filteranordnung, bei der die Induktivitäten eines Filterzweigs (120, 122, 124) auf nur einen Schenkel (132, 134, 136) des mehrschenkligen Filterkerns (130) gewickelt sind, reduziert ist.

8. Dreiphasen-Oberschwingungs-Netzfilter (110;210: 260; 310; 360; 410; 460; 510) gemäß einem der Ansprüche 1 bis 7, bei der die kapazitive Energiespeichereinrichtung (150) eine Sternschaltung von Kondensatoren ist.

9. Dreiphasen-Oberschwingungs-Netzfilter (110; 210; 260; 310; 360; 410; 460; 510) gemäß einem der Ansprüche 1 bis 7, bei dem die kapazitive Energiespeichereinrichtung (150) eine Dreiecksschaltung von Kondensatoren ist.

10. Dreiphasen-Oberschwingungs-Netzfilter (110; 210; 260; 310; 360; 410; 460; 510) gemäß einem der Ansprüche 1 bis 9, der so ausgelegt ist, dass ein Strom, der bei einer vorgegebenen Nutzfrequenz durch den ersten, zweiten oder dritten Anschluss (152,154,156) der kapazitiven Energiespeichereinrichtung (150) fließt, vom Betrag her kleiner ist als ein Viertel eines Stroms, der bei einer maximal zulässigen Belastung des Filters durch den ersten, zweiten oder dritten Filtereingang (L1, L2, L3) fließt.

11. Verfahren zum Betreiben eines Dreiphasen-Netzfilter (110; 210; 260; 310; 360; 410; 460; 510) mit einem ersten Filterzweig (120) zwischen einem ersten Filtereingang (FE1; L1) und einem ersten Filterausgang (FA1; L11), wobei der erste Filterzweig (120) eine erste Serienschaltung von drei Induktivitäten (IND1, IND2, IND3) aufweist, die zwischen den ersten Filtereingang (L1) und den ersten Filterausgang (L13) geschaltet sind, und die auf drei verschiedene Schenkel (132, 134, 136) eines dreischenkligen Filterkerns (130) gewickelt sind, einem zweiten Filterzweig (122) zwischen einem zweiten Filtereingang (FE2; L2) und einem zweiten Filterausgang (FA2; L12), wobei der zweite Filterzweig (122) eine zweite Serienschaltung von drei Induktivitäten (IND4, IND5, IND6) aufweist, die zwischen den zweiten Filtereingang (L2) und den zweiten Filterausgang (L12) geschaltet sind, und auf drei verschiedene Schenkel (132, 134, 136) des dreischenkligen Filterkerns (130) gewickelt sind, und einem dritten Filterzweig (124) zwischen einem dritten Filtereingang (L3) und einem dritten Filterausgang (L13), wobei der dritte Filterzweig (124) eine dritte Serienschaltung von drei Induktivitäten (IND7, IND8, IND9) aufweist, die zwischen den dritten Filtereingang (L3) und den dritten Filterausgang (L13) geschaltet sind, und die auf drei verschiedene Schenkel des dreischenkligen Filterkerns gewickelt sind, wobei Eingangsinduktivitäten (IND1, IND4, IND7) oder Ausgangsinduktivitäten (IND3, IND6, IND9) der drei Filterzweige (120, 122, 124) auf unterschiedliche Schenkel (132, 134, 136) des dreischenkligen Filterkerns gewickelt sind,

wobei Eingangsinduktivitäten (IND1, IND4, IND7) oder Ausgangsinduktivitäten (IND3, IND 6, IND9) der drei Filterzweige (120, 122, 124) auf unterschiedliche Schenkel (132, 134, 136) des dreischenkligen Filterkerns gewickelt sind;
wobei der erste Filterzweig (120) eine erste Querinduktivität (IND10) umfasst;
wobei der zweite Filterzweig (122) eine zweite Querinduktivität (IND11) umfasst;
wobei der dritte Filterzweig (124) eine dritte Querinduktivität (IND12) umfasst;
wobei ein Knoten, an dem zwei Induktivitäten (IND1, IND2; IND2, IND3) der ersten Serienschaltung verbunden sind, über die erste Querinduktivität (IND10) mit einem ersten Anschluss (152) einer kapazitiven Energiespeichereinrichtung (150) gekoppelt ist;
wobei ein Knoten, an dem zwei Induktivitäten (IND4, IND5; IND5, IND6) der zweiten Serienschaltung verbunden sind, über die zweite Querinduktivität (IND11) mit einem zweiten Anschluss (154) der kapazitiven Energiespeichereinrichtung (150) gekoppelt ist;
wobei ein Knoten, an dem zwei Induktivitäten (IND7, IND8; IND8, IND9) der dritten Serienschaltung verbunden sind, über die dritte Querinduktivität (IND12) mit einem dritten Anschluss (156) der kapazitiven Energiespeichereinrichtung (150) gekoppelt ist; und
wobei die drei Querinduktivitäten (IND10, IND11, IND12) auf den drei Schenkeln des dreischenkligen Filterkerns angeordnet sind,
wobei das Verfahren ein Weiterleiten von Nutz-Wechselströmen von dem ersten Filtereingang zu dem ersten Filterausgang und von dem zweiten Filtereingang zu dem zweiten Filterausgang umfasst.

## Claims

1. A three-phase harmonic line filter (110; 210; 260; 310; 360; 410; 460; 510), comprising:

   a first filter branch (120) between a first filter input (FE1; L1) and a first filter output (FA1; L11), the first filter branch (120) comprising a first series connection of three inductances (IND1, IND2, IND3) connected between the first filter input (L1) and the first filter output (L13) and wound onto three different legs (132, 134, 136) of a three-leg filter core (130);
   a second filter branch (122) between a second filter input (FE2; L2) and a second filter output (FA2; L12), the second filter branch (122) comprising a second series connection of three inductances (IND4, IND5, IND6) connected between the second filter input (L2) and the second filter output (L12) and wound onto three different legs (132, 134, 136) of the three-leg filter core (130); and
   a third filter branch (124) between a third filter input (L3) and a third filter output (L13), the third filter branch (124) comprising a third series connection of three inductances (IND7, IND8, IND9) connected between the third filter input (L3) and the third filter output (L13) and wound onto three different legs of the three-leg filter core,
   wherein input inductances (IND1, IND4, IND7) or output inductances (IND3, IND6, IND9) of the three filter branches (120, 122, 124) are wound onto different legs (132, 134, 136) of the three-leg filter core;
   wherein the first filter branch (120) includes a first shunt inductance (IND10);
   wherein the second filter branch (122) includes a second shunt inductance (IND11);
   wherein the third filter branch (124) includes a third shunt inductance (IND12);
   wherein a node where two inductances (IND1, IND2; IND2, IND3) of the first series connection are connected is coupled to a first terminal (152) of capacitive energy storage means (150) via the first shunt inductance (IND10);
   wherein a node where two inductances (IND4, IND5; IND5, IND6) of the second series connection are connected is coupled to a second terminal (154) of the capacitive energy storage means (150) via the second shunt inductance (IND11);

wherein a node where two inductances (IND7, IND8; IND8, IND9) of the third series connection are connected is coupled to a third terminal (156) of the capacitive energy storage means (150) via the third shunt inductance (IND12); and

wherein the three shunt inductances (IND10, IND11, IND12) are arranged on the three legs of the three-leg filter core.

2. The three-phase harmonic line filter (110; 210; 260; 310; 360; 410; 460; 510) according to claim 1, wherein the three-phase line filter is implemented to pass on useful alternating currents of a predetermined frequency from the first filter input (FE1; L1) to the first filter output (FA1; L11) and from the second filter input (FE2; L2) to the second filter output (FA2; L12) to attenuate at the first filter output (FA1; L11) disturbing currents of a frequency other than the predetermined frequency occurring at the first filter input (FE1; L1) or to attenuate at the second filter input (FE2; L2) disturbing currents occurring at the second filter output (FA2; L12).

3. The three-phase harmonic line filter (110; 210; 260; 310; 360; 410; 460; 510) according to claim 1 or 2, wherein the first filter branch (120) includes a first inductance (IND1) connected between the first filter input (L1) and a first node, a second inductance (IND2) connected between the first node and the first filter output (L11), and a third inductance (IND10) coupled to the first node to form a first shunt branch of the polyphase line filter; and

wherein the second filter branch (122) includes a fourth inductance (IND4) connected between the second filter input and a second node, a fifth inductance (IND5) connected between the second node and the second filter output (L12), and a sixth inductance (IND11) coupled to the second node to form a second shunt branch of the polyphase line filter;

wherein the second inductance (IND2) and the fourth inductance (IND4) are wound onto the same leg (134) of the three-leg filter core (130).

4. The three-phase harmonic line filter (110; 210; 260; 310; 360; 410; 460; 510) according to claim 3, wherein the third inductance (IND10) is coupled to a first terminal (152) of capacitive energy storage means (150), and wherein the sixth inductance (IND11) is coupled to a second terminal (154) of the capacitive energy storage means (150).

5. The polyphase harmonic line filter (110; 210; 260; 310; 360; 410; 460; 510) according to claim 1 or 2, wherein the first filter branch (120) includes a first node coupled to two inductances (IND1, IND2) of the series connection of inductances of the first filter branch (120);

wherein the second filter branch (122) includes a second node coupled to two inductances (IND4, IND5) of the series connection of inductances of the second filter branch; and

wherein the first node is coupled to a first terminal (152) of capacitive energy storage means (150), and wherein the second node is coupled to a second terminal (154) of the capacitive energy storage means (150).

6. The three-phase harmonic line filter (110; 210; 260; 310; 360; 410; 460; 510) according to one of claims 1 to 5, wherein the inductances (IND1, IND2, IND3, IND4, IND5, IND6, IND7, IND8, IND9) of the first, second and third series connections comprise an equal direction of winding.

7. The three-phase harmonic line filter (110; 210; 260; 310; 360; 410; 460; 510) according to one of claims 1 to 6, wherein the series connections, with regard to numbers of windings of the inductances (IND1, IND2, IND3, IND4, IND5, IND6, IND7, IND8, IND9) and with regard to a distribution of the inductances (IND1, IND2, IND3, IND4, IND5, IND6, IND7, IND8, IND9) onto the legs (132, 134, 136) of the multi-leg filter core (130), are implemented such that a magnetic flux in a leg (132, 134, 136) of the multi-leg filter core is reduced referenced to a filter arrangement where the inductances of a filter branch (120, 122, 124) are wound onto a single leg (132, 134, 136) of the multi-leg filter core (130).

8. The three-phase harmonic line filter (110; 210; 260; 310; 360; 410; 460; 510) according to one of claims 1 to 7, wherein the capacitive energy storage means (150) is a star connection of capacitors.

9. The three-phase harmonic line filter (110; 210; 260; 310; 360; 410; 460; 510) according to one of claims 1 to 7, wherein the capacitive energy storage means (150) is a triangular connection of capacitors.

10. The three-phase harmonic line filter (110; 210; 260; 310; 360; 410; 460; 510) according to one of claims 1 to 9, implemented such that a current flowing at a predetermined useful frequency through the first, second or third terminal (152, 154, 156) of the capacitive energy storage means (150) has a smaller magnitude than a fourth of a current flowing at a maximum allowed load the filter through the first, second or third filter input (L1, L2, L3).

11. A method of operating a three-phase line filter (110; 210; 260; 310; 360; 410; 460; 510) comprising a first filter branch (120) between a first filter input (FE1; L1) and a first filter output (FA1; L11), the first filter branch (120) comprising a first series connection of three inductances (IND1, IND2, IND3) connected between the first filter input (L1) and the first filter output (L13) and wound onto three different legs (132, 134, 136) of a three-leg filter core (130), a second filter branch (122) between a second filter input (FE2; L2) and a second filter output (FA2; L12), the second filter branch (122) comprising a second series connection of three inductances (IND4, IND5, IND6) connected between the second filter input (L2) and the second filter output (L12) and wound onto three different legs (132, 134, 136) of the three-leg filter core (130), and a third filter branch (124) between a third filter input (L3) and a third filter output (L13), the third filter branch (124) comprising a third series connection of three inductances (IND7, IND8, IND9) connected between the third filter input (L3) and the third filter output (L13) and wound onto three different legs of the three-leg filter core, the input inductances (IND1, IND4, IND7) or output inductances (IND3, IND6, IND9) of the three filter branches (120, 122, 124) being wound onto different legs (132, 134, 136) of the three-leg filter core, wherein input inductances (IND1, IND4, IND7) or output inductances (IND3, IND6, IND9) of the three filter branches (120, 122, 124) are wound onto different legs (132, 134, 136) of the three-leg filter core; wherein the first filter branch (120) includes a first shunt inductance (IND10); wherein the second filter branch (122) includes a second shunt inductance (IND11); wherein the third filter branch (124) includes a third shunt inductance (IND12); wherein a node where two inductances (IND1, IND2; IND2, IND3) of the first series connection are connected is coupled to a first terminal (152) of capacitive energy storage means (150) via the first shunt inductance (IND10); wherein a node where two inductances (IND4, IND5; IND5, IND6) of the second series connection are connected is coupled to a second terminal (154) of the capacitive energy storage means (150) via the second shunt inductance (IND11); wherein a node where two inductances (IND7, IND8; IND8, IND9) of the third series connection are connected is coupled to a third terminal (156) of the capacitive energy storage means (150) via the third shunt inductance (IND12); and wherein the three shunt inductances (IND10, IND11, IND12) are arranged on the three legs of the three-leg filter core, the method including passing on useful alternating currents from the first filter input to the first filter output and from the second filter input to the second filter output.

## Revendications

1. Filtre réseau de composantes harmoniques triphasé (110; 210; 260; 310; 360; 410; 460; 510), aux caractéristiques suivantes:

une première branche de filtre (120) entre une première entrée de filtre (FE1; L1) et une première sortie de filtre (FA1; L11), la première branche de filtre (120) présentant un premier circuit sériel de trois inductances (IND1, IND2, IND3) connectées entre la première entrée de filtre (L1) et la première sortie de filtre (L13), et qui sont enroulées sur trois branches différentes (132, 134, 136) d'un noyau de filtre à trois branches (130); une deuxième branche de filtre (122) entre une deuxième entrée de filtre (FE2; L2) et une deuxième sortie de filtre (FA2; L12), la deuxième branche de filtre (122) présentant un deuxième circuit sériel de trois inductances (IND4, IND5, IND6) connectées entre la deuxième entrée de filtre (L2) et la deuxième sortie de filtre (L12), et qui sont enroulées sur trois branches différentes (132, 134, 136) du noyau de filtre à trois branches (130); et une troisième branche de filtre (124) entre une troisième entrée de filtre (L3) et une troisième sortie de filtre (L13), la troisième branche de filtre (124) présentant un troisième circuit sériel de trois inductances (IND7, IND8, IND9) connectées entre la troisième entrée de filtre (L3) et la troisième sortie de filtre (L13), et qui sont enroulées sur trois branches différentes du noyau de filtre à trois branches, des inductances d'entrée (IND1, IND4, IND7) ou des inductances de sortie (IND3, IND6, IND9) des trois branches de filtre (120, 122, 124) étant enroulées sur des branches différentes (132, 134, 136) du noyau de filtre à trois branches; la première branche de filtre (120) comportant une première inductance transversale (IND10); la deuxième branche de filtre (122) comportant une deuxième inductance transversale (IND11); la troisième branche de filtre (124) comportant une troisième inductance transversale (IND12); un noeud auquel sont reliées deux inductances (IND1, IND2; IND2, IND3) du premier circuit sériel étant couplé par l'intermédiaire de la première inductance transversale (IND 10) à une première connexion (152) d'un moyen d'accumulation d'énergie capacitif (150);

un noeud auquel sont reliées deux inductances (IND4, IND5; IND5, IND6) du deuxième circuit sériel étant couplé par l'intermédiaire de la deuxième inductance transversale (IND11) à une deuxième connexion (154) du moyen d'accumulation d'énergie capacitif (150);

un noeud auquel sont reliées deux inductances (IND7, IND8; IND8, IND9) du troisième circuit sériel étant couplé par l'intermédiaire de la troisième inductance transversale (IND12) à une troisième connexion (156) du moyen d'accumulation d'énergie capacitif (150); et

les trois inductances transversales (IND10, IND11, IND12) étant disposées sur les trois branches du noyau de filtre à trois branches.

2.  Filtre réseau de composantes harmoniques triphasé (110; 210; 260; 310; 360; 410; 460; 510) selon la revendication 1, dans lequel le filtre réseau de composantes harmoniques est réalisé de manière à transmettre des courants alternatifs utiles de fréquence prédéterminée de la première entrée de filtre (FE 1; L1) à la première sortie de filtre (FA 1; L11) et de la deuxième entrée de filtre (FE2; L2) à la deuxième sortie de filtre (FA2; L12), pour atténuer à la première entrée de filtre (FE1; L1) des courants parasites de fréquence autre que la prédéterminée qui se présentent à la première sortie de filtre (FA1; L11), ou pour atténuer à la deuxième entrée de filtre (FE2; L2) qui se présentent à la deuxième sortie de filtre (FA2; L12).

3.  Filtre réseau de composantes harmoniques triphasé (110; 210; 260; 310; 360; 410; 460; 510) selon la revendication 1 ou 2, dans lequel la première branche de filtre (120) comporte une première inductance (IND1) connectée entre la première entrée de filtre (L1) et un premier noeud, une deuxième inductance (IND2) connectée entre le premier noeud et la première sortie de filtre (L11), ainsi qu'une troisième inductance (IND10) couplée au premier noeud, pour former une première branche transversale du filtre réseau triphasé; et

dans lequel la deuxième branche de filtre (122) comporte une quatrième inductance (IND4) connectée entre la deuxième entrée de filtre et un deuxième noeud, une cinquième inductance (IND5) connectée entre le deuxième noeud et la deuxième sortie de filtre (L12), ainsi qu'une sixième inductance (IND11) couplée au deuxième noeud, pour former une deuxième branche transversale du filtre réseau triphasé;

la deuxième inductance (IND2) et la quatrième inductance (IND4) étant enroulées sur la même branche (134) du noyau de filtre à trois branches (130).

4.  Filtre réseau de composantes harmoniques triphasé (110; 210; 260; 310; 360; 410; 460; 510) selon la revendication 3, dans lequel la troisième inductance (IND10) est couplée à une première connexion (152) d'un moyen d'accumulation d'énergie capacitif (150), et dans lequel la sixième inductance (IND11) est couplée à une deuxième connexion (154) du moyen d'accumulation d'énergie capacitif (150).

5.  Filtre réseau de composantes harmoniques triphasé (110; 210; 260; 310; 360; 410; 460; 510) selon la revendication 1 ou 2, dans lequel la première branche de filtre (120) comporte un premier noeud couplé à deux inductances (IND1, IND2) du circuit sériel d'inductances de la première branche de filtre (120);

dans lequel la deuxième branche de filtre (122) comporte un deuxième noeud couplé à deux inductances (IND4, IND5) du circuit sériel d'inductances de la deuxième branche de filtre; et

dans lequel le premier noeud est couplé à une première connexion (152) d'un moyen d'accumulation d'énergie capacitif (150), et dans lequel le deuxième noeud est couplé à une deuxième connexion (154) du moyen d'accumulation d'énergie capacitif (150).

6.  Filtre réseau de composantes harmoniques triphasé (110; 210; 260; 310; 360; 410; 460; 510) selon l'une des revendications 1 à 5, dans lequel les inductances (IND1, IND2, IND3, IND4, IND5, IND6, IND7, IND8, IND9) du premier, du deuxième et du troisième circuit sériel présentent un sens d'enroulement.

7.  Filtre réseau de composantes harmoniques triphasé (110; 210; 260; 310; 360; 410; 460; 510) selon l'une des revendications 1 à 6, dans lequel les circuits sériels sont conçus, en ce qui concerne les nombres de spires des inductances (IND1, IND2, IND3, IND4, IND5, IND6, IND7, IND8, IND9) et en ce qui concerne une répartition des inductances (IND1, IND2, IND3, IND4, IND5, IND6, IND7, IND8, IND9) sur les branches (132, 134, 136) du noyau de filtre à plusieurs branches (130), de sorte qu'un flux magnétique dans une branche (132, 134, 136) du noyau de filtre à plusieurs branches soit réduit par rapport à un aménagement de filtre dans lequel les inductances d'une branche de filtre (120, 122, 124) sont enroulées sur une seule branche (132, 134, 136) du noyau de filtre à plusieurs branches (130).

8.  Filtre réseau de composantes harmoniques triphasé (110; 210; 260; 310; 360; 410; 460; 510) selon l'une des revendications 1 à 7, dans lequel le moyen d'accumulation d'énergie capacitif (150) est un circuit sériel de condensateurs.

9. Filtre réseau de composantes harmoniques triphasé (110; 210; 260; 310; 360; 410; 460; 510) selon l'une des revendications 1 à 7, dans lequel le moyen d'accumulation d'énergie capacitif (150) est un circuit triangulaire de condensateurs.

10. Filtre réseau de composantes harmoniques triphasé (110; 210; 260; 310; 360; 410; 460; 510) selon l'une des revendications 1 à 9, qui est conçu de sorte qu'un courant circulant à une fréquence de réseau prédéterminée à travers la première, la deuxième ou la troisième connexion (152, 154, 156) du moyen d'accumulation d'énergie capacitif (150) soit, en quantité, inférieur un quart d'un courant circulant à une sollicitation maximal admissible du filtre à travers la première, la deuxième ou la troisième entrée de filtre (L1, L2, L3).

11. Procédé pour faire fonctionner un filtre réseau triphasé (110; 210; 260; 310; 360; 410; 460; 510) avec une première branche de filtre (120) entre une première entrée de filtre (FE1; L1) et une première sortie de filtre (FA1; L11), la première branche de filtre (120) présentant un premier circuit sériel d'inductances (IND1, IND2, IND3) connectées entre la première entrée de filtre (L1) et la première sortie de filtre (L13) et enroulées sur trois branches différentes (132, 134, 136) d'un noyau de filtre à trois branches (130), une deuxième branche de filtre (122) entre une deuxième entrée de filtre (FE2; L2) et une deuxième sortie de filtre (FA2; L12), la deuxième branche de filtre (122) présentant un deuxième circuit sériel de trois inductances (IND4, IND5, IND6) connectées entre la deuxième entrée de filtre (L2) et la deuxième sortie de filtre (L12) et enroulées sur trois branches différentes (132, 134, 136) du noyau de filtre à trois branches (130), et une troisième branche de filtre (124) entre une troisième entrée de filtre (L3) et une troisième sortie de filtre (L13), la troisième branche de filtre (124) présentant un troisième circuit sériel de trois inductances (IND7, IND8, IND9) connectées entre la troisième entrée de filtre (L3) et la troisième sortie de filtre (L13) et enroulées sur trois branches différentes du noyau de filtre à trois branches, les inductances d'entrée (IND1, IND4, IND7) ou les inductances de sortie (IND3, IND6, IND9) des trois branches de filtre (120, 122, 124) étant enroulées sur des branches différentes (132, 134, 136) du noyau de filtre à trois branches,
les inductances d'entrée (IND1, IND4, IND7) ou les inductances de sortie (IND3, IND 6, IND9) des trois branches de filtre (120, 122, 124) étant enroulées sur des branches différentes (132, 134, 136) du noyau de filtre à trois branches;
la première branche de filtre (120) comportant une première inductance transversale (IND 10);
la deuxième branche de filtre (122) comportant une deuxième inductance transversale (IND11);
la troisième branche de filtre (124) comportant une troisième inductance transversale (IND12);
un noeud auquel sont reliées deux inductances (IND1, IND2; IND2, IND3) du premier circuit sériel étant couplé par l'intermédiaire de la première inductance transversale (IND10) à une première connexion (152) d'un moyen d'accumulation d'énergie capacitif (150);
un noeud auquel sont reliées deux inductances (IND4, IND5; IND5, IND6) du deuxième circuit sériel étant couplé par l'intermédiaire de la deuxième inductance transversale (IND11) à une deuxième connexion (154) du moyen d'accumulation d'énergie capacitif (150);
un noeud auquel sont reliées deux inductances (IND7, 15 IND8; IND8, IND9) du troisième circuit sériel étant couplé par l'intermédiaire de la troisième inductance transversale (IND12) à une troisième connexion (156) du moyen d'accumulation d'énergie capacitif (150); et
les trois inductances transversales (IND10, IND11, IND12) étant disposées sur les trois branches du noyau de filtre à trois branches,
le procédé comprenant une transmission de courants alternatifs utiles de la première entrée de filtre à la première sortie de filtre et de la deuxième entrée de filtre à la deuxième sortie de filtre.

FIG. 1

FIG. 2

FIG. 3

FIG. 4

EP 1 805 879 B1

FIG. 5

FIG. 6

FIG. 7

EP 1 805 879 B1

FIG. 8

EP 1 805 879 B1

FIG. 9

FIG. 10

610

A: a∗M1+b=
10 ms
100 A
======

A

630

B: Eres(M2)=
10 ms
100 A
======

B

630

10 ms    BWL
1 .2   V   DC ×/100
2 .2   V   DC
3 50 mV DC
4 50 mV DC ×/100

1   DC 23.6 V

1 MS/s

□ STOPPED

EP 1 805 879 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 9601517 A